(19) Europäisches Patentamt
European Patent Office
Office européen des brevets

(11) **EP 4 642 179 A2**

(12) **EUROPEAN PATENT APPLICATION**

(43) Date of publication:
**29.10.2025 Bulletin 2025/44**

(51) International Patent Classification (IPC):
**H05K 7/20** (2006.01)

(21) Application number: 25167817.3

(22) Date of filing: **01.04.2025**

(52) Cooperative Patent Classification (CPC):
**H05K 7/20272**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **01.04.2024 US 202463572608 P
13.09.2024 US 202463694633 P**

(71) Applicant: **Hoffman Enclosures, Inc.
Anoka, MN 55303 (US)**

(72) Inventors:
• **Kundem, Jeshwanth Durga Sagar
Minneapolis (US)**
• **Speight, Jacob
Anoka (US)**
• **Raisanen, Richard
Coon Rapids (US)**

(74) Representative: **Barker Brettell LLP
100 Hagley Road
Edgbaston
Birmingham B16 8QQ (GB)**

(54) **ACTUATOR ASSEMBLIES FOR COOLING SYSTEMS**

(57) A blind-mate connection system for fluid ports of a liquid cooling system can include a housing defining a fluid inlet and a fluid outlet. An inlet fluid coupler can be in fluid communication with the fluid inlet, and an outlet fluid coupler can be in fluid communication with the fluid outlet. The inlet and outlet fluid couplers can face in a first direction and allow fluid flow parallel to a first axis. A guide structure can constrain housing movement transverse to the first axis. The system can include a manual engagement interface rotatable about a rotation axis, where rotation in a first direction produces linear translation of the housing in an insertion direction parallel to the first axis. A retention mechanism can oppose rotation of the manual engagement interface in a direction opposite the first direction.

FIG. 1

EP 4 642 179 A2

**Description**

CROSS REFERENCE TO RELATED APPLICATIONS

The present application claims the benefit of and priority to U.S. Provisional Patent Application 63/572,608, filed on April 1, 2024, and U.S. Provisional Patent Application 63/694,633, filed on September 13, 2024, each of which is incorporated by reference herein in its entirety, for any and all purposes.

BACKGROUND

Cooling systems can be provided for electrical components in data centers. In some cases, equipment in a data center can be cooled with various approaches, including with liquid-based cooling systems, air-based cooling systems, or combinations thereof. Electrical equipment within a data center can be housed in racks and can include piping and manifolds for receiving a liquid coolant pumped through a liquid cooling circuit. The liquid coolant can be delivered to components of electrical equipment (e.g., via pumps) to remove heat from those components.

SUMMARY

Embodiments of the disclosed technology can provide improved cooling systems. Some embodiments of the disclosed technology provide a system and method for hot swapping pumps of cooling systems.

According to some embodiments, a blind-mate connection system for fluid ports of a liquid cooling system is provided. The blind-mate connection system can include a housing defining a fluid inlet and a fluid outlet. The system can include an inlet fluid coupler in fluid communication with the fluid inlet and an outlet fluid coupler in fluid communication with the fluid outlet. The inlet and outlet fluid couplers can both be fixed to the housing and can be configured to matably engage corresponding fluid couplers of a removable component. The inlet and outlet fluid couplers can each face in a first direction and can be configured to allow a flow of fluid through the respective fluid coupler in a direction parallel to a first axis. The system can include a guide structure configured to at least partially constrain a movement of the housing in a direction transverse to the first axis. The system can also include a manual engagement interface configured to rotate about a rotation axis, wherein a rotation of the manual engagement interface in a first direction can produce a linear translation of the housing in an insertion direction, the insertion direction being parallel to the first axis. Additionally, the system can include a retention mechanism configured to oppose a rotation of the manual engagement interface about the rotation axis in a direction opposite the first direction.

In some embodiments, the blind-mate connection system can further include a lead screw with a threaded end, where the lead screw can be rotatable about the rotation axis. The manual engagement interface can include a knob, wherein a rotation of the knob can produce a corresponding rotation of the lead screw, and wherein the first axis can be parallel to the rotation axis.

In some embodiments, the retention mechanism can comprise a ratchet gear secured to the lead screw and positioned within the housing, and a pawl movable between an engaged configuration and a disengaged configuration. The pawl can be in contact with the ratchet gear in the engaged configuration and not in contact with the ratchet gear in the disengaged configuration.

In some embodiments, the threaded end can comprise a multi-start thread. In some embodiments, the guide structure can comprise a plate defining a threaded aperture, wherein the threaded end can be sized to be received into the threaded aperture. In some embodiments, the knob can define a square opening sized to receive a square head of a tool.

In some embodiments, the manual engagement interface can include a handle movable between an open position and a closed position, wherein the rotational axis can be transverse to the first axis. In some embodiments, the guide structure can comprise a mounting structure including a protruding pin, the mounting structure configured to at least partially receive the housing, and a bracket including an elongate slot extending in a direction parallel to the first axis, wherein the protruding pin of the mounting structure can be received within the elongate slot.

According to some embodiments, a method of establishing a blind-mate connection for fluid ports of a liquid cooling system is provided. The method can include positioning a housing defining a fluid inlet and a fluid outlet, the housing having an inlet fluid coupler in fluid communication with the fluid inlet and an outlet fluid coupler in fluid communication with the fluid outlet. The inlet and outlet fluid couplers can both be fixed to the housing and facing in a first direction, the inlet and outlet fluid couplers configured to allow a flow of fluid through the respective fluid coupler in a direction parallel to a first axis. The method can include rotating a manual engagement interface about a rotation axis in a first direction to produce a linear translation of the housing in an insertion direction, the insertion direction being parallel to the first axis, to matably engage the inlet and outlet fluid couplers with corresponding fluid couplers of a removable component. The method can also include engaging a retention mechanism to oppose rotation of the manual engagement interface about the rotation axis in a direction opposite the first direction.

In some embodiments, rotating the manual engagement interface can comprise rotating a knob to produce a corresponding rotation of a lead screw about the rotation axis. In some embodiments, engaging the retention mechanism can comprise engaging a pawl with a ratchet gear secured to the lead screw and positioned within the housing. The pawl can be movable between an engaged configuration and a disengaged configuration. The pawl can be in contact with the ratchet gear in the engaged configuration and not in contact with the ratchet gear in the disengaged configuration.

In some embodiments, rotating the lead screw can include rotating the lead screw that includes a multi-start thread. In some embodiments, the method can further comprise engaging a threaded end of the lead screw with a guide structure to constrain movement of the housing in a direction transverse to the first axis.

In some embodiments, the manual engagement interface can include a handle movable between an open position and a closed position, and rotating the manual engagement interface can comprise moving the handle from the open position to the closed position. In some embodiments, the rotational axis can be transverse to the first axis.

According to some embodiments, an actuator assembly for providing a blind-mate connection of fluid ports of a liquid cooling system is provided. The actuator assembly can include a housing defining a fluid inlet and a fluid outlet that each extend in a first direction and are configured to receive a flow of fluid through the fluid inlet and the fluid outlet in a direction parallel to a first axis. The assembly can include a manual engagement interface configured to rotate about a rotation axis, wherein a rotation of the manual engagement interface in a first direction can produce a linear translation of the housing in an insertion direction, the insertion direction being parallel to the first axis. The assembly can include a lead screw that is connected to the manual engagement interface and includes a threaded end. The assembly can also include a retention mechanism configured to oppose a rotation of the manual engagement interface about the rotation axis in a direction opposite the first direction. The retention mechanism can include a ratchet gear secured to the lead screw and positioned within the housing, and a pawl can be movable between an engaged configuration and a disengaged configuration. The pawl can be in contact with the ratchet gear in the engaged configuration and not in contact with the ratchet gear in the disengaged configuration.

In some embodiments, the actuator assembly can further include a guide structure that includes a threaded aperture that is configured to engage with the threaded end of the lead screw to constrain a movement of the housing in a direction transverse to the first axis. In some embodiments, the threaded end can include a multi-start thread. In some embodiments, the manual engagement interface can include a knob. In some embodiments, the knob can define a square opening sized to receive a square head of a tool.

Features which are described in the context of separate aspects and/or embodiments of the invention may be used together and/or be interchangeable wherever possible. Similarly, where features are, for brevity, described in the context of a single embodiment, those features may also be provided separately or in any suitable sub-combination. Features described in connection with the blind-mate connection system or other apparatus or component(s) described may have corresponding features definable and/or combinable with respect to a method or vice versa, and these embodiments are specifically envisaged.

BRIEF DESCRIPTION OF THE DRAWINGS

The accompanying drawings, which are incorporated in and form a part of this specification, help illustrate various features of non-limiting examples of the disclosure and are not intended to limit the scope of the disclosure or exclude alternative implementations.

FIG. 1 is an isometric view of an actuator assembly according to an example of the disclosure.

FIG. 2 is a side elevation view of the actuator assembly of FIG. 1.

FIG. 3 is a side elevation view of a linkage of the actuator assembly of FIG. 1.

FIG. 4 is a side elevation view of a bracket of the actuator assembly of FIG. 1.

FIG. 5 is a side elevation view of a cam member of the actuator assembly of FIG. 1.

FIG. 6 is a side elevation view of the actuator assembly of FIG. 1 in a closed configuration.

FIG. 7 is a side elevation view of the actuator assembly of FIG. 1 in an open configuration.

FIG. 8 is an isometric view of an actuator assembly in an open configuration, according to an example of the disclosure.

FIG. 9 is an isometric view of an actuator assembly according to another example of the disclosure.

FIG. 10 is an isometric view of an actuator assembly according to yet another example of the disclosure.

FIG. 11 is an isometric view of an actuator assembly according to an example of the disclosure.

FIG. 12 is an isometric partial view of a coolant distribution unit, showing the actuator assembly of FIG. 8 in a closed configuration according to an example of the disclosure.

FIG. 13 is an isometric partial view of the coolant distribution unit of FIG. 12, showing the actuator assembly of FIG. 8 in an open configuration.

FIG. 14 is a graph illustrating a relationship between an angle of a handle of an actuator and various applied forces in an example implementation.

FIG. 15 is a top, front, right isometric view of an actuator assembly for blind mate fluid connections, according to an example of the disclosure.

FIG. 16 is a rear elevation view of the actuator assembly of FIG. 15.

FIG. 17 is a partial isometric view of the actuator assembly of FIG. 15, with a housing and fluid flow elements of the actuator assembly removed to show a locking system of the actuator assembly.

FIG. 18 is a bottom plan view of a lead screw of a locking system, according to an example of the disclosure.

FIG. 19 is a bottom plan view of a lead screw of a locking system, according to an example of the disclosure.

FIG. 20 is a bottom plan view of a lead screw of a locking, according to an example of the disclosure.

FIG. 21 is a plot of experimental data illustrating a relationship between hydraulic pressure and torque applied to a screw of a locking system for an example actuator assembly, according to some examples of the disclosure.

FIG. 22 is a plot illustrating test results for a displacement of elements of a retention system for an actuator assembly when a pawl is disengaged from a ratchet gear, and for an installation torque for a retention system at given system fluid pressures.

FIG. 23 is a top, front, right isometric view of an actuator assembly, according to an example of the disclosure.

FIG. 24 is a top, rear, left isometric view of the actuator assembly of FIG. 23.

FIG. 25 is a cross-sectional view of the actuator assembly of FIG. 23, taken along line 25-25.

FIG. 26 is a perspective view of the actuator of FIG. 23.

FIG. 27 is a partial isometric partial view of an in-rack CDU including the actuator assembly of FIG. 23 according to some aspects of the disclosure.

FIG 28 is an isometric partial view of reservoir pumping unit (RPU) including a removable pump cassette with an actuator assembly, according to some examples.

FIG. 29 is an axonometric view of a knob for an actuator assembly, according to an example of the disclosure.

DETAILED DESCRIPTION

Before any embodiments of the disclosed technology are explained in detail, it is to be understood that the disclosed technology is not limited in its application to the details of construction and the arrangement of components set forth in the following description or illustrated in the following drawings. The disclosed technology is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use embodiments of the disclosed technology. Various modifications to the illustrated embodiments will be readily apparent to those skilled in the art, and the generic principles herein can be applied to other embodiments and applications without departing from embodiments of the disclosed technology. Thus, embodiments of the disclosed technology are not intended to be limited to embodiments shown but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of embodiments of the disclosed technology. Skilled artisans will recognize the examples provided herein have many useful alternatives and fall within the scope of embodiments of the disclosed technology.

Cooling systems can be provided for data centers to cool electrical components within a data center. During operation, electrical components, typically housed in racks having a standard rack footprint (e.g., a standard height, width, and depth), generate heat. As that heat may degrade electrical components, damage the systems, or degrade performance of the components, cooling systems can be provided for data centers for transferring heats away from racks of the data center with electrical components that need to be cooled. As performance requirements increase for electrical (e.g., computing) equipment, increasingly, liquid cooling systems are used to cool the electrical equipment (e.g., to provide greater cooling capacity and cooling density compared to conventional air-based cooling systems).

Cabinets or racks containing electrical equipment are typically arranged in rows within a data center, defining aisles between consecutive rows. Racks can be pre-assembled and "rolled in" to a space in the row adjacent to other racks, the space being pre-defined to have the footprint of a standard rack. This arrangement allows a modular construction of or addition to components in a data center. In some configurations, aisles on opposite sides of a rock of cabinets can be alternately designated as a cold aisle, or a hot aisle, and heat generated by the electrical components of a cabinet can be expelled to the hot air aisle.

Cooling systems can be provided for electrical equipment to transfer a heat away from heat-generating components (e.g., computing chips), as can advantageously prevent an overheating or a damage to the electrical components from heat. In some cases, cooling systems can include a transfer of heat to or from a liquid to perform a cooling of electrical equipment. For example, coolant distribution units (CDUs) can be provided for cooling systems to distribute a liquid to heat-generating electrical components (e.g., through direct-to-chip or immersion cooling) and heat from the heat-generating electrical components can be transferred to the liquid to cool the components. In some cases, cooling systems can include air-to-liquid cooling units, liquid-to-air cooling units, liquid-to-liquid cooling units, in-row CDUs, in-rack CDUs, etc.

It can be advantageous within liquid cooling systems to provide fluid interfaces (e.g., ports, connections, etc.) that can be substantially leak-free and can allow for tool-less insertion and removal of components of the cooling systems. For example, liquid cooling systems can include components that can require a removal for servicing or replacement (e.g., how swapped), and it can advantageously reduce a labor cost for the system to provide for a tool-less removal and replacement of those components. Liquid connections (e.g., quick-disconnect fittings) can be configured for tool less engagement within a cooling system, and can further be configured (e.g., sized and positioned) for "blind mate" connections within the cooling system. For example, components within a CDU can be configured to be inserted into the CDU in a particular orientation, and when inserted, liquid ports of the component can align with liquid ports of the CDU. A fluid connection between the CDU and the component (e.g., a blind mate connection) can be established when the component is properly aligned (e.g., ports of the component and the CDU can automatically engage when the component is inserted) without the need for a manual connection of fluid ports. Some examples of the present disclosure can provide blind mate connection interfaces for replaceable pumps, filtration units, in-rack CDUs, replaceable heat exchanger units, valve assemblies, rear-door cooling units, and any other modular component along a fluid flow path within a liquid cooling system.

Fluid flowing through a liquid cooling loop can comprise a closed fluid circuit, and the closed fluid circuit can be pressurized. In some examples, a fluid coolant within a liquid cooling circuit can be pressurized to a desired pressure (e.g., about 1 bar, about 2 bars, about 3 bars, or between 1-3 bars). In some cases, a fluid pressure for a fluid in a fluid circuit can provide a force opposing a connection of components of a liquid cooling system at an interface (e.g., between ports at respective fluid sides of a quick-disconnect fitting). For example, fluid within a cooling system may be pressurized, and a hydraulic pressure can oppose a mating force at an interface between couplers of a modular component (e.g., a replaceable pump unit, an in-rack CDU, modular filtration units, heat exchange units, valve units, a liquid-cooled server chassis, etc.) and couplers of cooling system (e.g., couplers of an actuator assembly, of a CDU, a rack of electronic equipment, ports on a fluid manifold, etc.). Further, in some cases, a modular component (e.g., an in-rack CDU, a replaceable pump cassette, etc.) can be "charged" with a fluid (e.g., pre-filled with a fluid coolant) at a predetermined pressure before being integrated with a liquid cooling system, as can advantageously prevent the introduction of air bubbles into the liquid cooling system and minimize a disruption in an operating pressure of the system when the component is installed. A pressure of the liquid cooling circuit and a fluid pressure of the coolant within the modular component can oppose a fluid connection between the modular component and the liquid cooling circuit (e.g., can oppose mating of the ports of the liquid cooling circuit and the modular component). In some cases, the hydraulic pressure can be greater than 30 psi, greater than 40 psi, greater than 50 psi, or greater than 60 psi. Hydraulic pressure can cause couplers (e.g., quick-disconnect ports) of the modular component and the liquid cooling circuit to be pushed apart (e.g., partially or fully disconnected). In some cases, the fluid pressure can displace the modular component from an installed position as could produce a fluid disconnection, an interruption in an operation of cooling systems, etc. Therefore, it can be advantageous to provide a retention system to retain a removable component within a cooling system to overcome a separation force due to the pressurized fluid and to maintain the fluid connection. According to the present disclosure, retention systems can include locking mechanisms for blind mate fluid connections to overcome a fluid pressure at a connection interface (e.g., quick-disconnect ports of a blind mate connection interface). Some examples of the present disclosure can provide efficient locking mechanisms capable of maintaining a fluid connection between ports of a removable component and ports of a liquid cooling system (e.g., a closed fluid circuit) into which the removable component is installed (e.g., the disclosed retention systems can overcome a fluid pressure opposing a fluid connection between ports of the removable component and the liquid cooling system).

Some examples of the present disclosure can include actuator assemblies that can provide a translation (e.g., a linear movement) of liquid ports (e.g., liquid ports of either of a removable component or a system into which the removable component is installed) in a direction to mate with other liquid ports. Actuator assemblies according to the present disclosure can include retention systems to overcome a separation force between liquid ports when the ports are in fluid communication. In some examples, the disclosed actuator assemblies can be used during an installation or removal of a pump (e.g., a pump of an in-rack CDU or an RPU along a liquid cooling circuit). While the examples shown and described below reference liquid connections of pumps of a cooling system, the disclosed technology is not limited to the described examples. Actuator assemblies, according to the present disclosure can be used to overcome a separating force (e.g., a fluid pressure, a spring force, an air pressure etc.) when translating an element in a linear direction in engagement with another system. For example, actuator assemblies can be used for inserting components within a rack (e.g., servers, network switches, in-rack CDUs, in-rack cooling units, disk shelfs, etc.).

In some examples, actuator assemblies can provide mechanical advantage to a user in overcoming a separation force to engage and maintain an engagement between fluid ports of respective component. For example, an actuator assembly can include an input mechanism (e.g., a cam) that transmits rotational input motion into a linear output motion (e.g., with a cam and slider mechanism). In some examples, the cam can include a handle that creates a lever arm to reduce a level of applied force that is needed to overcome hydraulic pressure of the coolants at the coupler interfaces. A shape of a cam can be designed to maintain a linear position of ports (e.g., to maintain a connection of ports) when the cam is rotated to or beyond a desired position. Thus, the mechanical advantage of the cam can allow fluid or electric connections of the pump to be formed with greater ease and correspondingly provide associated cooling systems with a greater degree of serviceability.

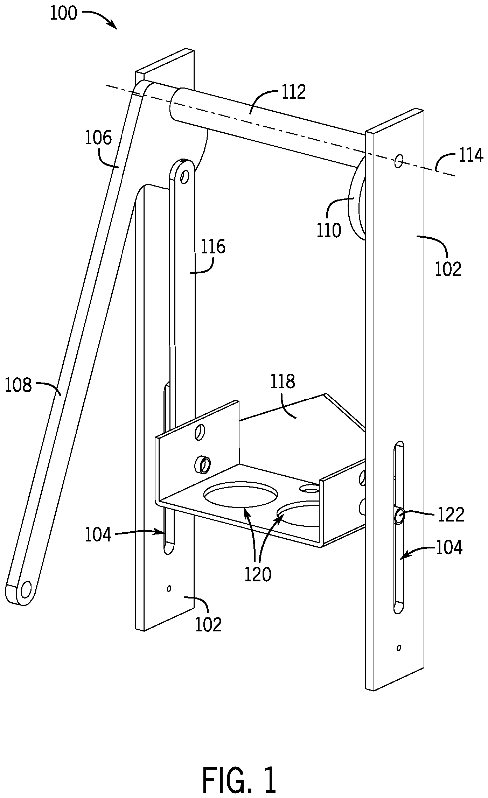

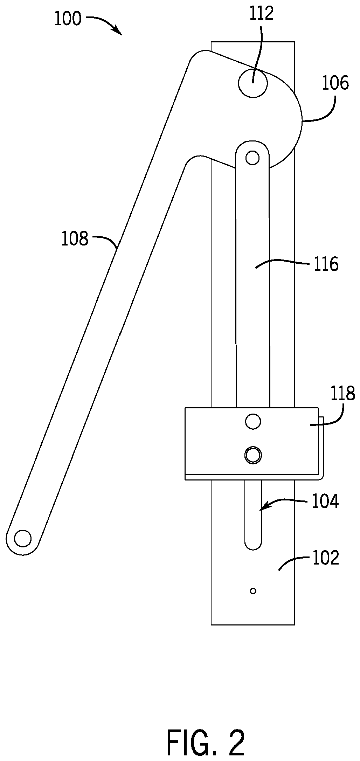

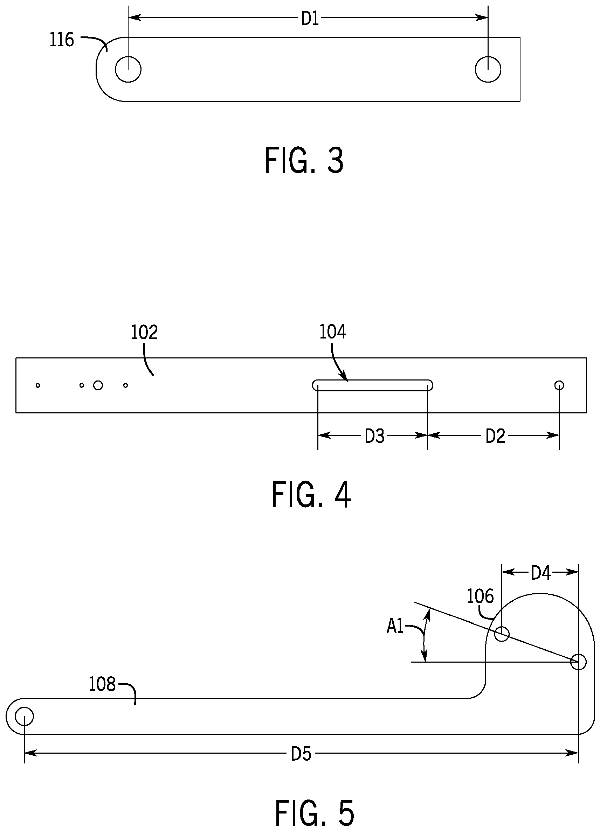

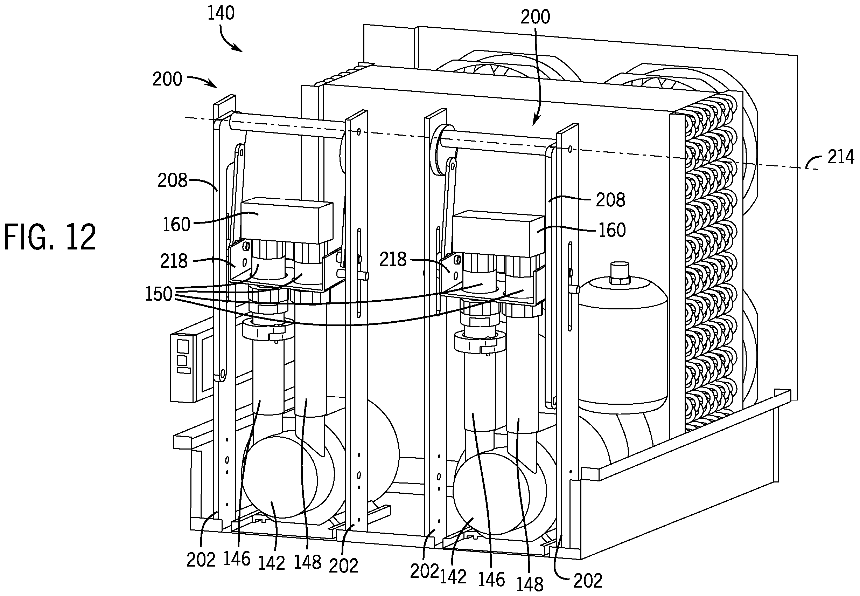

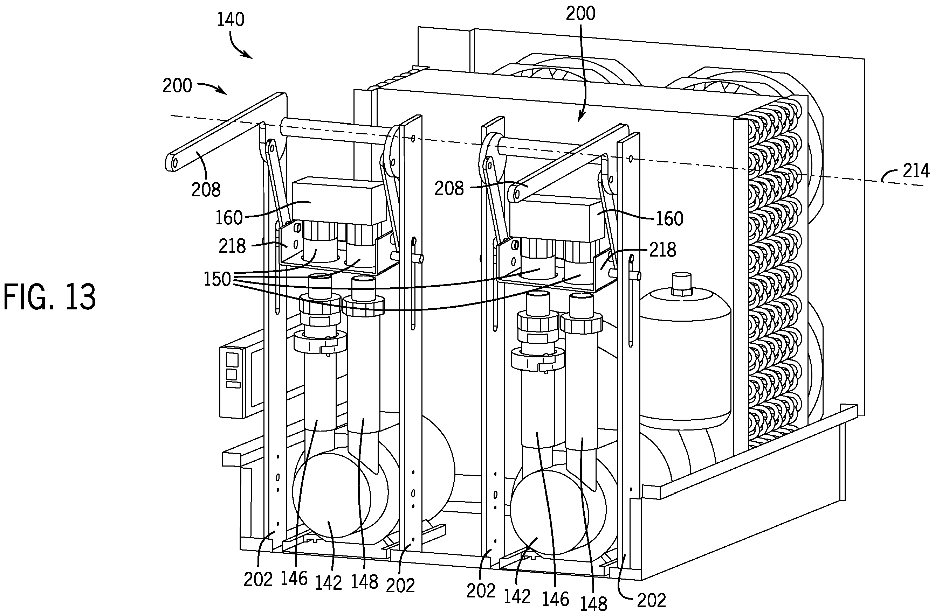

FIGS. 1-7 illustrate an example of an actuator assembly 100 for facilitating a connection of ports of a liquid cooling system (e.g., an in-rack CDU, an in-row CDU, an RPU, etc.) and a removable component (e.g., removable pumps, filter assemblies, heat exchangers, valve assemblies, etc.). In a particular example, as shown in FIGS. 12 and 13 and described below, the actuator assembly can facilitate a hot-swappability of a respective pump of an in-rack CDU (e.g., pumps 142), and can provide a blind mate connection for the pump. As shown, the actuator assembly 100 can include a plurality of linkages (e.g., a four-bar linkage system) that are capable of engaging and/or disengaging pipe connections. The actuator assembly 100 can include brackets 102 (shown individually in FIG. 4), a first cam 106 (shown individually in FIG. 5), a second cam 110, and a rod 112 (e.g., an axle) that extends between the brackets 102 and the first and second cams 106, 110.

Brackets and cams of an actuator assembly can be coupled in a way that allows a rotational movement of the cams relative to the brackets. In some cases, for example, a rod defining a rotational axis can extend through apertures in each of the brackets and the cams. In the illustrated example, the brackets 102 include locating features (e.g., through-holes, as shown), and the first and second cams 106, 110 include protrusions (e.g., pins, as shown) that can engage with the locating features (e.g., protrusions of the cams 106, 110 can extend through corresponding apertures of the brackets 102 to fix a vertical position of the cams 106, 110 relative to the brackets 102). Alternatively or additionally, the rod 112 can include protrusions that can engage with the first and second cams 106, 110 or apertures that can receive the fasteners on the first and second cams 106, 110. In other examples, the rod 112 can include protrusions that can extend through the brackets 102 and the first and second cams 106, 110 to connect one another. Or various other known types of rotatable structural connections can be provided between a cam assembly (e.g., the cams 106, 110 and the rod 112) and one or more support brackets (e.g., the brackets 102), as can prevent a translation of the cams in one or more directions relative to the brackets, while allowing for a rotation of the cams relative to the brackets.

As shown, a pivot axis 114 (e.g., a rotational axis) can extend through the rod 112, the brackets 102, and the first and second cams 106, 110. The rod 112 and the first and second cams 106, 110 can rotate relative to the brackets 102 about the pivot axis 114. In some examples, the rod 112 can be fixed (e.g., glued, welded, fastened, etc.) to the first and second cams 106, 110, such that the rod 112, the first and second cams 106, 110 rotate about the pivot axis 114 as a unified linkage body. In other examples, a rod can define a rotational axis for a cam (e.g., can extend through the cam and allow rotation of the cam relative to the rod) while the rod itself does not rotate with the cam.

A user interface can be provided for actuator assemblies to allow a user to manually indue a rotation of cams of the actuator assembly. For example, a lever arm can be provided for the cam (e.g., can be integral with the cam) and can provide an operator with a mechanical advantage when engaging the lever to produce a rotation of the cam. As further shown in the illustrated example, the first cam 106 includes a handle 108 that extends from the first cam 106 transverse to the rotational axis 114 (e.g., perpendicular to the axis 114, with a radial offset from the axis 114). As shown in FIG. 5, the first cam 106 includes pivot points that are spaced apart by a distance D4 and angled apart by an angle A1 relative to the handle 108. For example, the first 106 can include a first pivot point (e.g., right point as shown in FIG. 5) at which the rod 112 is connected to and a second pivot point (e.g., left point as shown in FIG. 5) at which a linkage 116 is connected to. In some cases, D4 can between 30 mm and 60 mm, between 40 mm and 50 mm, or about 45 mm. In some cases, A1 can be less than 60 degrees, less than 45 degrees, less than 30 degrees, or about 20 degrees. Further, the first pivot point of the first cam 106 and a distal end of the handle 108 can be spaced from each other by a distance D5. In some cases, D5 can be between 200 mm and 400 mm, between 250 mm and 350 mm, or about 306 mm. In some cases, one or more dimensions of the first cam 106 or the handle 108 (e.g., D4, D5, or A1) can be adjusted to provide a desired configuration of a lever arm.

As will be discussed in detail below, force can be applied to the handle 108 to rotate the first cam 106 about the pivot axis 114, with corresponding rotation of the rod 112 and the second cam 110. Thus, the handle 108 can provide a moment arm between the pivot axis 114 and the applied force to produce an amplified torque about the pivot axis 114. In some examples, a length of the handle 108 can be different (i.e., shorter or longer) to vary a radius of the motion and a corresponding mechanical advantage.

Continuing, the actuator assembly 100 can include linkages that are capable of transmitting a rotational movement by the handle 108 into a linear translation of a portion of the actuator assembly (e.g., a support or block for fluid ports coupled to the actuator assembly). For example, as shown, the actuator assembly 100 can include the linkages 116 (shown individually in FIG. 3) that are pivotally connected to the first and second cams 106, 110 at a pivot point below the pivot axis 114 (i.e., between the pivot axis 114 and the system to be connected, as also generally shown in FIG. 13).

When the first and second cams 106, 110 rotate about the pivot axis 114, the pivot point at which the linkages 116 are connected to the respective cams 106, 110 can also be rotated about the axis 114. The rotation of the pivot points can produce a displacement of the linkages 116 in a vertical direction (e.g., a direction parallel with an elongate direction of the brackets 102). Further, the movement of the linkages 116 can be confined by interactions with other members of the actuator assembly 100. For example, the linkages 116 can be pivotally connected to a port retention structure 118 of the actuator assembly 100 that is configured to engage with the brackets 102. For example, as shown, the brackets 102 include elongate slots 104 that extend linearly along a length of the brackets and receive pins 122 that extend through or from respective lateral sides of the port retention structure 118. As shown in FIG. 4, the slots 104 can include a length D3 and be spaced from a pivot point at which the rod 112 can be connected to by a distance D2. In some examples, D3 can be between 50 mm and 150 mm, between 80 mm and 120 mm, or about 100 mm. In some examples, D2 can be between 100 mm and 150 mm, between 110 mm and 140 mm, or about 120 mm. In some examples, various dimensions of the brackets 102, including D2 and D3, can be adjusted to provide desired kinematics of the actuator assembly 100.

When the pins 122 of the port retention structure 118 are received into the respective slots 104, a movement of the port retention structure can be limited to a translation in the vertical direction (e.g., a direction parallel to the elongate direction of the slots 104) as the pins 122 slide within the slots 104. The pins 122 can also extend through the linkages 116, which can be positioned between the port retention structure 118 and the brackets 102. Thus, as the linkages 166 rotate about the axis 114 at the pivot points that connect the linkages 116 and the first and second cams 106, 110, the linkages 116, the pins 122, and the port retention structure 118 can be displaced in a direction parallel to an elongate direction of the slots 104 (e.g., can be raised or lowered relative to the brackets 102). In some cases, an axis can extend through a pivot point between a linkage and a port retention structure and can also extend through elongate slots of a bracket and the pins extending into the slots. In other cases, a pivot point (e.g., an attachment point between a linkage and a port retention structure) can be placed at a different vertical or horizontal location than a pin extending into a slot (e.g., the pivot point is not coaxial with the pins). In some cases, a port retention structure can include features to allow for adjustability of the linkage relative to the port retention structure, as can allow the actuator assembly to be used in different systems requiring different spacing requirements for ports. For example, a port retention structure can include multiple apertures to receive a corresponding protrusion (e.g., a pin) of a linkage at a plurality of predefined positions.

In some examples, the linkages 116 can include pivot points that are spaced apart by a distance D1. For example, the linkages 116 can include a first pivot point (e.g., left point as shown in FIG. 3) at which the first cam 106 can be connected to and a second pivot point (e.g., right point as shown in FIG. 3) at which a port retention structure 118 can be connected to. In some cases, D1 can be between 80 mm and 120 mm, or between 90 mm and 110 mm, or about 112 mm. In some cases, D1 can be adjusted to provide desired kinematics between components of the actuator assembly 100. In some examples, D1 can be adjusted to increase or decrease the distance between the port retention structure 118 and the axis 114. In some examples, D1 can be adjusted based on predefined positions of fluid ports or couplers.

Generally, the port retention structure 118 can be configured to support fluid or electrical couplers, or to be moved relative to the brackets 102 via movement of the handle 108. As shown in FIG. 1, for examples, the port retention structure 118 can include openings 120 that are sized to receive various mechanical parts, including fluid or electrical couplers of various known configurations. In the illustrated example, the port retention structure 118 includes a plurality of side walls and a bottom plate (e.g., a plate in which the openings 120 are defined). The plurality of side walls and plates can be dimensioned to at least partially define a negative volume into which a fluid block can be installed and maintained. A fluid block, as further shown and described below can be a housing that can fix a spatial relationship between inlet and outlet fluid couplers (e.g., a distance between respective ports), and can thereby facilitate a blind mate or partial blind mate connection between respective elements of a liquid cooling system. In some cases, the actuator assembly 100 can support couplers (e.g., quick-disconnect ports) directly at the openings 120, without requiring a fluid block. As will be discussed in detail below, the couplers can be hydraulic quick-connect fittings that connect hosing or other conduits to a fluid outlet and fluid inlet of a pump. The port retention structure 118 can support the weight or force of the couplers in some cases and, thus, help to enhance connecting of fluid couplers or electrical connection of a component (e.g., blind mate connections of a removable component with an in-rack CDU).

In different examples, different configurations are possible. For example, while the openings 120 are positioned in a left-to-right direction, the openings 120 can be positioned in a front-to-back direction. Additionally or alternatively, the openings 120 need not be next to each other. Sizes or numbers of the openings 120 can be different for different types of the pipes, and some configurations may not include openings at all (e.g., may instead include other support structure for relevant couplers). In some examples, the port retention structure 118 can be disengaged from the brackets 102 and be replaced with a differently shaped or sized plate (e.g., to accommodate different types of pumps). In some examples, the port retention structure 118 can have a back panel that includes shapes (e.g., triangular, rectangular, hexagonal, or polygonal shapes, etc.) that can increase rigidity of the port retention structure 118.

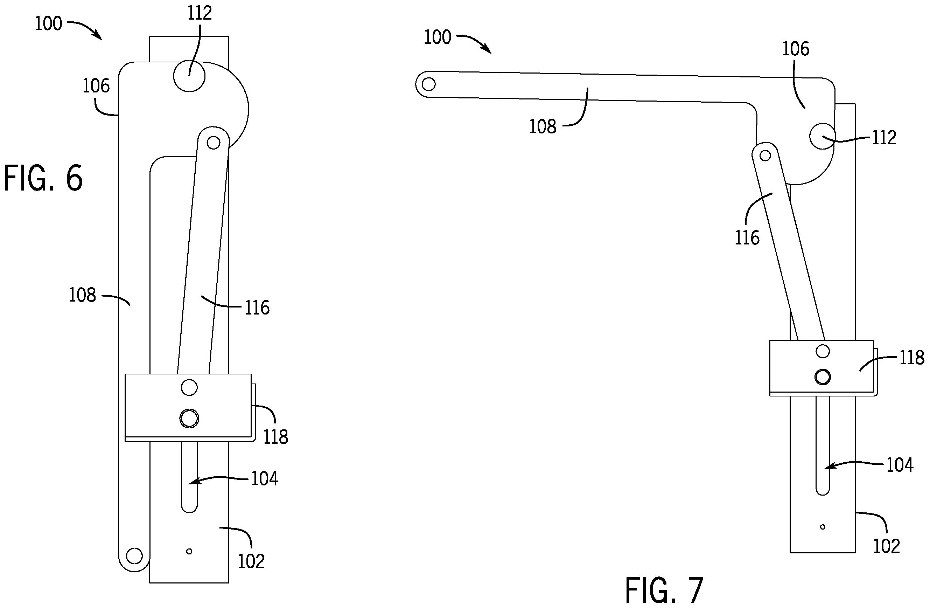

Referring to FIG. 6, the actuator assembly 100 is illustrated in a closed configuration. In this state, the handle 108 can be approximately parallel to the brackets 102 to provide a relatively small overall footprint, although other configurations are possible. Correspondingly, the port retention structure 118 can be at a lowest height based on a geometry of the linkages 116 (e.g., length, connection points, etc.) and other relevant components. In some examples, in the closed configuration, the pins 122 (shown in FIG. 1) may not be flushed against bottom ends of the slots 104. Thus, for example, the blind ends of the slots 104 may not limit the connecting force provided via the handle 108. As shown in FIG. 6, the arrangement of the cams 106, 110, the brackets 102, the linkages 116, and the port retention structure 118 can provide a force opposing a separation force at couplers or ports of a liquid cooling system (e.g., a separation force acting on the port retention structure 118 in an upward direction towards the rod 112). In the illustrated example, a rotation of the cam 106 about the rod 112 in a counterclockwise direction (e.g., a closing direction), as viewed from the perspective of FIG. 6, can be limited by a stopping feature that can engage the handle 108 to prevent further rotation. For example, when rotated in a counterclockwise direction the handle 108 can ultimately come into contact with the port retention structure 118, which can prevent a further rotation of the handle 108 and thus the cam 106. As shown in FIG. 6, when the handle 108 is in the closed position, the pivot point between the linkage 116 and the cam 106 is positioned to the right of the rod 112, as viewed from the perspective of FIG. 6. Thus, when an upward force is exerted at the port retention structure 118, the corresponding force produced at the pivot point between the linkage 116 and the cam 106 produces a moment about the rod 112 in a counterclockwise direction as viewed from the perspective of FIG. 6. As further rotation in the counterclockwise direction is prevented by the engagement of the handle 108 with a stopping feature, the positioning of the pivot point between the cam 106 and the linkage 116 can provide a locking feature that can prevent a disengagement of ports of the actuator assembly 100 from ports of a corresponding component.

Referring to FIG. 7, the actuator assembly 100 is illustrated in an open configuration. In this state, the handle 108 can be approximately perpendicular to the brackets 102 to provide easy access and favorable ergonomics for application of closing force, although other configurations are possible. The port retention structure 118 can be at a higher height than when the actuator assembly 100 is in the closed configuration, and the pins 122 (shown in FIG. 1) may be flush against upper ends of the slots 104 (e.g., so that the slots 104 provide a positive indication of reaching a fully open configuration).

In particular, from the closed configuration of FIG. 6, when the handle 108 is rotated outward (i.e., in a counterclockwise direction) about the pivot axis 114 (shown in FIG. 1), the linkages 116 can swing upward in the counterclockwise direction due to the linkages 116 being connected to the first and second cams 106, 110 at upper ends. Due to the geometry of the first cam 106, the linkages 116 can be lifted closer to the pivot axis 114 than when the actuator assembly 100 is in the closed configuration. Since bottom ends of the linkages 116 are pivotally engaged with the pins 122 that are positioned within the slots 104, the upward movement of the linkages 116 can also lift the port retention structure 118 upward. When the pins 122 bump into upper ends of the slots 104, a movement of the handle 108 may be restricted (i.e., the handle 108 may no longer rotate).

In the present example, the handle 108 may be rotated in a clockwise direction as viewed from the perspective of FIGS. 6 and 7 (i.e., toward an operator) to operate the actuator assembly 100 from the closed configuration to the open configuration. This may be due to the location of the pivot axis 114 that is positioned at an upper portion of the actuator assembly 100. However, in some examples, the pivot axis 114 may be positioned at different parts of the brackets 102, e.g., at a lower portion of the actuator assembly 100. In such case, for example, the handle 108 may be rotated in a clockwise direction (i.e., toward the operator) to operate the actuator assembly 100 from the closed configuration to the open configuration. Similarly, other configurations may exhibit other directions of rotation, or other structural variations, without departing from the principles of operation discussed above.

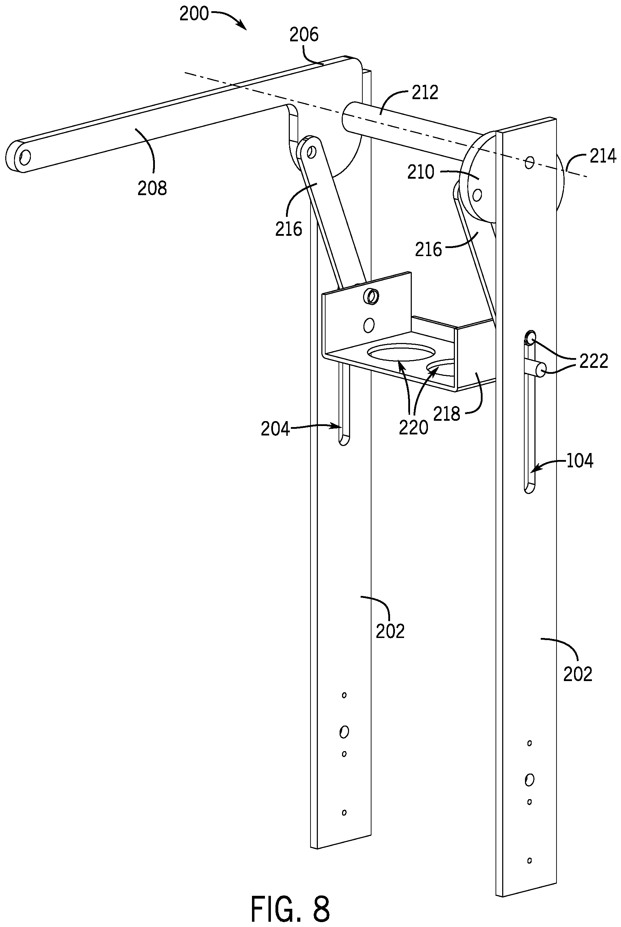

FIG. 8 illustrates an example of an actuator assembly 200, which is one particular example of the actuator assembly 100 illustrated in FIGS. 1-7. To that end, features of the actuator assembly 200 described below include reference numbers that are generally similar to those used in FIG. 1 and discussion of numbered features above applies to correspondingly numbered features below. For example, the actuator assembly 200 has brackets 202, just as the actuator assembly 100 has brackets 102.

The actuator assembly 200 can be supported by the brackets 202 that include slots 204. The actuator assembly 200 can include a first cam 206 and a second cam 210 that engage with the brackets 202 and a rod 212 and rotate about a pivot axis 214. The first and second cams 206, 210 can engage with linkages 216 to raise or lower a port retention structure 218 in a vertical direction, as a handle 208 of the first cam 206 rotates about the pivot axis 214. The port retention structure 218 can engage with the brackets 202 via a plurality of pins 222. In particular, upper pins of the plurality of pins 222 can engage with linkages, such that when the actuator assembly 200 is in an open configuration (as shown in FIG. 8), the upper pins abut upper ends of the slots 204. In some examples, the linkages 216 may engage with lower pins of the plurality of pins to elevate a maximum height of the port retention structure 218 in the open configuration.

In some examples, a length of the linkages 216 may be varied (e.g., shortened or lengthened) to vary the maximum height of the port retention structure 218 in the open configuration. The brackets 202 are generally longer than the brackets 102 of FIGS. 1-7, such that the port retention structure 218 may be held at a higher (relative) altitude than the port retention structure 118 of the brackets 102. Additionally or alternatively, the linkages 216 can be connected to the first and second cams 206, 210 at different spots, or the first and second cams 206, 210 can be sized differently, such that the port retention structure 218 can be raised to a higher height in the open configuration. A back plate of the port retention structure 218 can be shaped approximately rectangular as shown, but other shapes such as triangular, hexagonal, circular, etc. are possible. In some examples, the port retention structure 218 can include openings 220 that are sized and positioned to receive pipes and/or couplers therethrough.

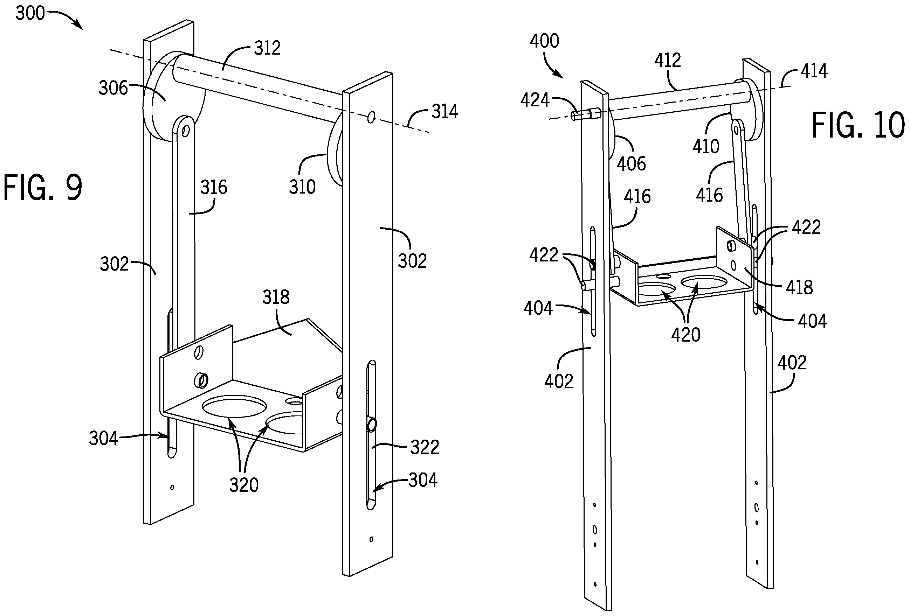

FIG. 9 illustrates an example actuator assembly 300, which is similar to the actuator assembly 100 of FIGS. 1-7 or the actuator assembly 200 of FIG. 8. To that end, features of the actuator assembly 300 described below include reference numbers that are generally similar to those used in FIGS. 1-8 and discussion of above applies to similar numbers below unless otherwise noted or required. For example, the actuator assembly 300 is described as having brackets 302, just as the actuator assembly 100 has the brackets 102.

The actuator assembly 300 can be supported by the brackets 302 that include slots 304. The actuator assembly 300 can include a first cam 306 and a second cam 310 that engage with the brackets 302 and a rod 312 and rotate about a pivot axis 314. The first and second cams 306, 310 can engage with linkages 316 to raise or lower a plate 318 in a vertical direction, as pins 322 slide through the slots 304. The plate 318 can include openings 320 that are configured to receive pipes and/or couplers therethrough.

The first cam 306 or the second cam 310 can be actuated by various types of mechanisms, including a servo motor, a stepper motor, a magnetic motor, a direct current (DC) motor, a solenoid, and so on. In some examples, such mechanisms can be powered by a power source or can be operated manually. In some examples, a handle (not shown) can be retrofitted to the first cam 306 or the second cam 310, or the first cam 306 or the second cam 310 can be replaced with a cam including a handle (e.g., as similarly shown in FIG. 1). In some examples, a handle and a motorized mechanism can be used jointly or independently.

FIG. 10 illustrates an example actuator 400, which can be similar or identical to the actuator assembly 100 of FIGS. 1-7, the actuator assembly 200 of FIG. 8, or the actuator assembly 300 of FIG. 9. To that end, features of the actuator 400 described below include reference numbers that are generally similar to those used in FIGS. 1-9 and discussion of above applies to similar numbers below unless otherwise noted or required. For example, the actuator 400 is described as having brackets 402, just as the actuator assembly 100 has the brackets 102.

The actuator 400 can be supported by the brackets 402 that include slots 404. The actuator 400 can include a first cam 406 and a second cam 410 that engage with the brackets 402 and a rod 412 and rotate about a pivot axis 414. The first and second cams 406, 410 can engage with linkages 416 to raise or lower a plate 418 in a vertical direction, as pins 422 slide through the slots 404. The plate 418 can include openings 420 that are configured to receive pipes and/or couplers therethrough.

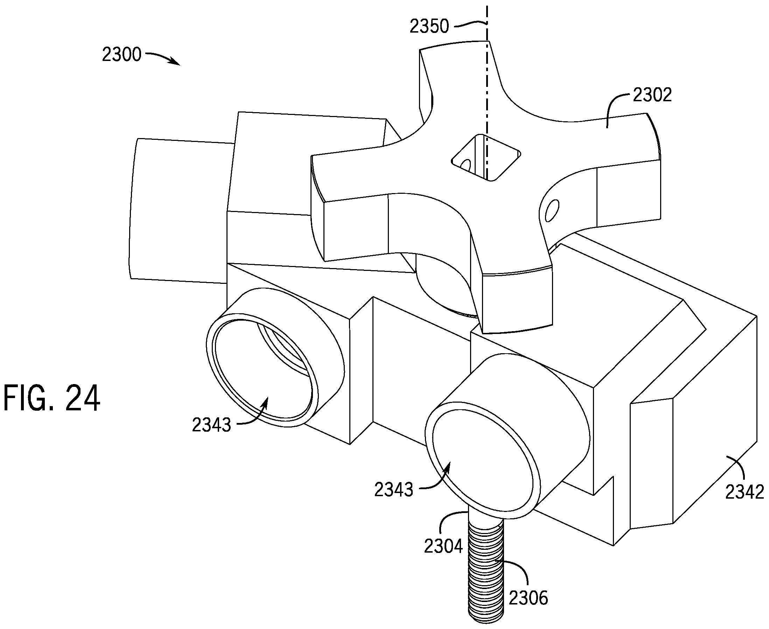

In this embodiment, the actuator 400 can include an interface 424 that engages with the first and second cams 406, 410 and the rod 412. The interface 424 can be sized to allow a tooled engagement with the interface 424 to produce a desired rotation of the cams 406, 410. In the illustrated example, the interface can comprise a hex-head protrusion that can be engaged with a ratchet wrench, a drill, a socket wrench etc. In some cases, the interface an include a negative space to receive a corresponding tool head. For example, an interface can include a square head aperture that can receive a square head of a socket wrench, a drill bit, etc. In some cases, a knob can be provided as an interface (e.g., a removable knob can be received onto the protrusion of the interface 424) as can allow an operator to manually rotate cams via an engagement with the knob. For example, in some cases, an actuator assembly (e.g., the actuator assembly 400 shown in FIG. 10) 406, 410 via the interface For example, the knob 2400 shown in FIG. 24 can be installed on the interface 424 of the actuator assembly 400, and can allow for a manual engagement, and an engagement using various tool heads to rotate the interface 424, as described further in FIG. 24.

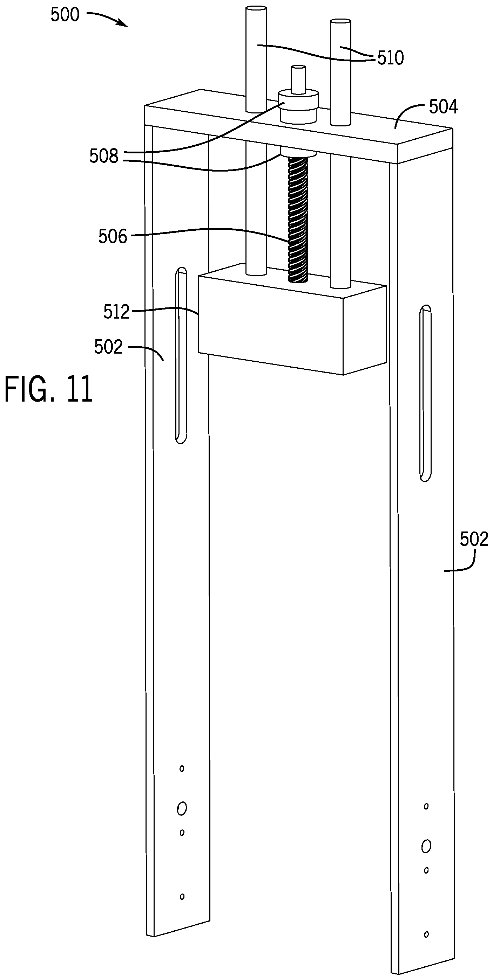

Continuing, FIG. 11 illustrates an actuator assembly 500 according to an example of the disclosure. The actuator assembly 500 can be a lead screw mechanism that actuator assembly 500can be adapted to actuate a blind mate connector for connection and disconnection within a CDU.

As shown in FIG. 11, the actuator assembly 500 can include brackets 502 and a plate 504 that can support a load of hydraulic connection. The actuator assembly 500 can also include a screw 506 (e.g., a lead screw) that extends through the plate 504. The screw 506 can rotate about a longitudinal axis of the screw 506 to raise or lower various parts of the actuator assembly 500. The actuator assembly 500 can include a plurality of fasteners 508 (e.g., a locking collar, a thrust bearing, etc.) that can constrain an axial movement of the screw 506. A block 512 (e.g., a blind mate carrier block) can be aligned with the brackets 502 by providing rods 510 that extend through the plate 504 and are attached to the block 512. In some examples, the block can be a manifold block that engages with blind mate couplers and allow fluids (e.g., coolants) to flow from a pump of the CDU to plumbing network. The block 512 can transmit hydraulic load of the fluids through the screw 506 and into the brackets 502. In some examples, the block 512 can advantageously provide sealing force to the blind mate couplers.

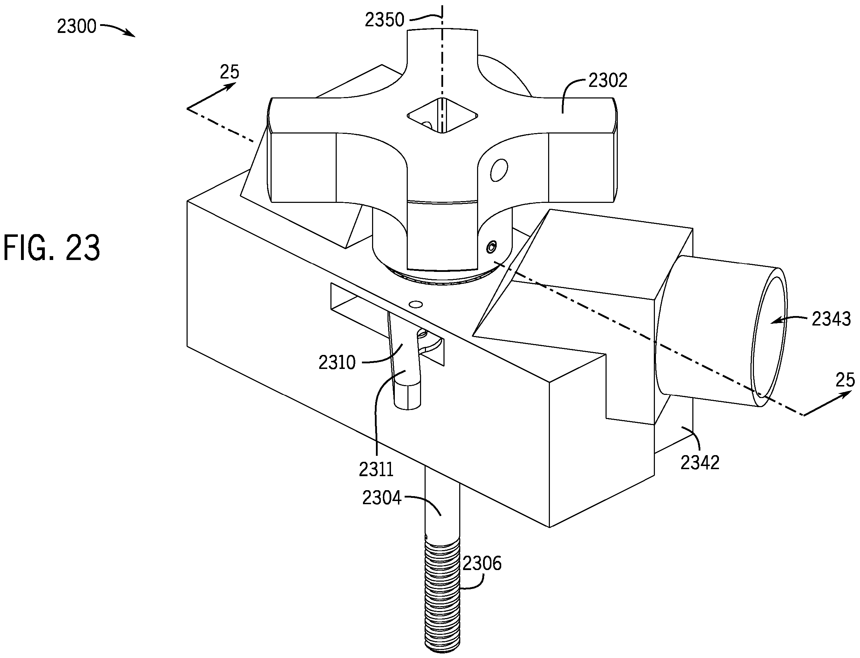

FIGS. 12 and 13 illustrate an in-rack CDU 140 including the actuator assembly 200 shown in FIG. 8. As noted above, the actuator assembly can be similar to the actuator assembly 100, and the description of the actuator assembly 100 can apply to the actuator assembly 200. In some examples, an in-rack CDU (e.g., CDU 140) can include any of the actuator assemblies 100, 200, 300, 400, and 500 shown and described above. As shown, the CDU 140 includes removable pumps 142 that include inlet conduits (e.g., pipes) 146 and outlet conduits (e.g., pipes) 148 that may be connected to a plumbing network of the CDU via couplers 150 fixably joined to the port retention structure 218. In some cases, the conduits 146, 148 each terminate in respective quick-disconnect couplers that can mate with the couplers 150. In the example shown, the couplers 150 are integrated with a manifold block 160. The manifold block 160 can include a housing that can fix a spatial relationship and orientation of the couplers 150 relative to each other. For example, the manifold block 160 can maintain a spacing of respective couplers 150 that can match a spacing between the terminal ports of the conduits 146, 148 and thus facilitate a blind mate connection of the removable pumps 142 with the CDU 140. In some cases, hosing of the CDU 140 (not shown) can be fluidly connected to an inlet port and an outlet port of the block 160 (e.g., similar of identical to ports 2343 of the manifold block 2342 shown in FIG. 23). In some examples, the couplers 150 can be quick disconnect fitting. In the illustrated example, the couplers 150 can be supported on the port retention structure 218. In some cases, the manifold block can include openings that are in fluid communication with downstream pipes and that may extend in a direction different than the orientation of the couplers 150.

As shown in FIG. 12, the actuator assembly 200 may be in a closed configuration with the handle 208 in parallel with the brackets 202 and the pipes 146, 148, or perpendicular to the pivot axis 214, or otherwise oriented. In the closed configuration, the couplers 150 are connected with respective ports at distal ends of the conduits 146, 148, and fluids from the pumps 142 may flow into and out of rest of the plumbing network (e.g., through the manifold block 160) to move heat from electronics (not shown) to a heat exchanger for rejection from the system.

FIG. 13 illustrates the actuator assembly 200 in an open configuration. The handle 208 may be rotated about the pivot axis 214 to form approximately a 90-degree angle with brackets 202, or various other configurations. As generally described above, the couplers 150 can be raised as the port retention structure 218 is lifted linearly, and the couplers 150 can thus be released (i.e., disengaged) from the ports at the distal ends of inlet and outlet pipes 146, 148. Subsequently, the relevant pump(s) 142 may be removed from service (e.g., replaced). While FIGS. 12 and 13 illustrate the CDU having one actuator assembly per pump, different numbers or configurations of actuators are possible (e.g., with one actuator provided per unit or per coupler, and so on).

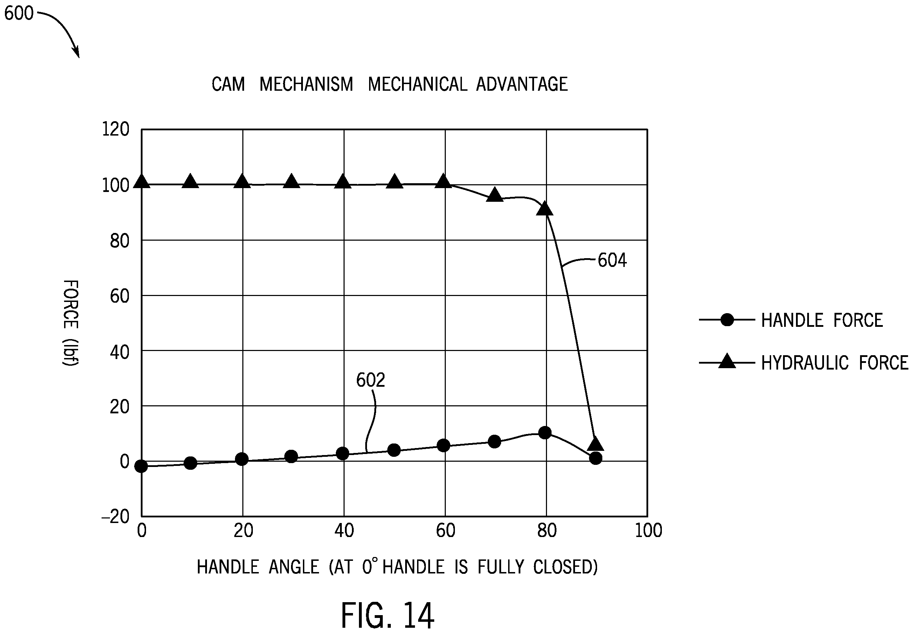

FIG. 14 illustrates a graph 600 illustrating example relationships between an angle of a handle of an actuator assembly meeting the specifications of actuator assembly 100 and various applied force values in pound force (lbf), assuming 100 lbf of force from fluid pressure at relevant couplers. Line 602 corresponds to a relationship between the angle of the handle and handle forces applied to the handle. Line 604 corresponds to a relationship between the angle of the handle and hydraulic forces of the couplers. When the handle is fully closed, the hydraulic forces acting on a plate of the actuator can force the handle to close (e.g., depicted by negative force values in the graph 600). This condition can apply as the handle is further opened, until there is approximately a 20-degree angle between the handle and brackets of the actuator. When the angle of the handle approaches approximately 90 degrees, as shown by the line 604, the hydraulic forces of the couplers can approach zero, indicating disengagement of the couplers. In the illustrated example, the maximum force required by the handle (i.e., manual force by an operator) can be about 16 lbf. Thus, a mechanical advantage of the actuator can be about 6.25 during operation of the actuator. The mechanical advantage can be significantly higher in a fully closed position, such as about 45, implying that a hydraulic load of 100 lbf may require no more than a manual force of 16 lbf to close the connection in some examples.

In some cases, an actuator assembly for blind mate connections (e.g., fluid connections, electrical connections, etc.) can incorporate a lead screw that can produce a linear displacement of blind mate connectors when the lead screw is rotated. Actuator assemblies incorporating lead screws can include retention mechanisms that can maintain a linear position of ports of the blind mate connection (e.g., opposing a separation force produced by fluid pressure at couplings). In some cases, retention systems can be provided that can limit a rotation of a lead screw when the retention mechanism is engaged, as can correspondingly prevent a linear translation (e.g., disengagement or disconnection) of ports. For example, a blind mate connection (e.g., a blind mate connection of a modular component of a liquid cooling system) can include a lead screw and a latch and pawl mechanism. The lead screw can extend in a direction parallel to ports (e.g., parallel to a direction of fluid flow between the cooling system and the modular component), and a threaded end of the lead screw can be received into a corresponding threaded aperture of the cooling system when the modular component is inserted into the cooling system. An operator can rotate the lead screw at an interface (e.g., a knob) to tighten or loosen the lead screw relative to the threaded aperture. Tightening the lead screw can bring ports of a modular component and the cooling system into closer engagement and a maintain a fluid connection at the ports. In this regard, a lead screw of a retention mechanism can at least partially oppose a separation force produced by a fluid pressure at ports of the modular component and the cooling system.

In some cases, retention mechanisms for modular components of a liquid cooling system can include self-locking screws. For example, the threaded end of the lead screw described above can include threads that are sized and configured along the lead screw to produce a self-locking effect when engaged within the threaded aperture. A self-locking effect can be achieved for a screw when the threads of the screw follow the following condition:

$$\pi * d_p * \mu_s > Lead \qquad \text{(Equation 1)}$$

with $d_p$ being a pitch diameter, $\mu_s$ being a coefficient of friction between a thread and an engaging thread, and a lead being a product of a number of starts of the thread and a pitch of the thread. A self-locking effect can be achieved for a screw by minimizing the Lead by reducing one or both of a number of starts of a thread and a pitch (e.g., an angle) of the thread. However, minimizing a lead (e.g., a size of a lead) can reduce an efficiency of the lead screw by requiring a greater number of rotations of the lead screw to achieve a desired displacement s compared to a number of rotations required to achieve the same displacement for a lead screw having a larger lead. There is therefore a need in the art to provide retention mechanisms that can provide a locking effect for a lead screw that produces an increased rotational efficiency (e.g., requires a fewer number of turns to achieve a seal for a blind mate connection) relative to retention mechanisms that rely on self-locking screws for a retention mechanism.

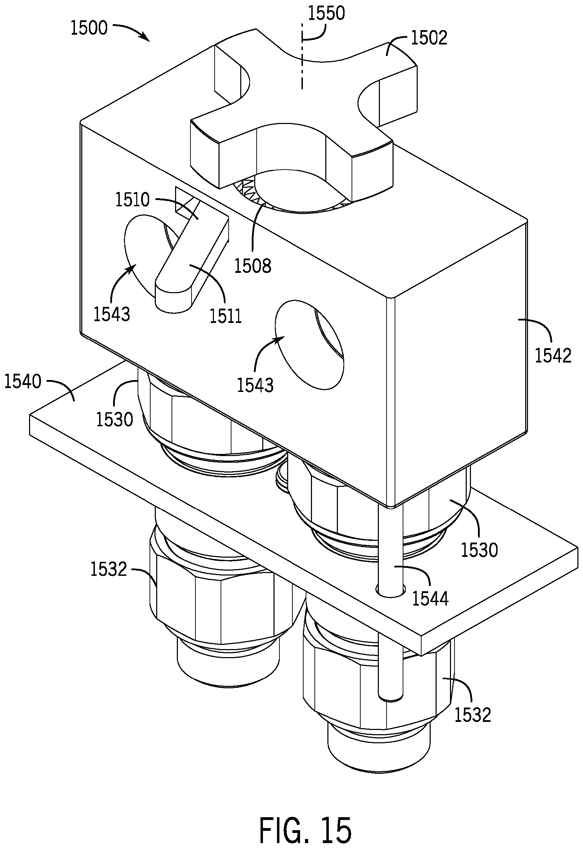

Some examples of the present disclosure can provide one or both of multi-start lead screws and lead screws with increased thread pitch relative to self-locking lead screws, as can advantageously increase a linear displacement of the lead screw for a given rotational displacement of the lead screw. Ratchet and pawl locking mechanisms can maintain a rotational position of the lead screw and can prevent a rotation of the lead screw when the latch and pawl are engaged (e.g., a rotation produced by a linear force exerted on the retention mechanism by a fluid pressure). FIGS. 15-17 illustrate an example actuator assembly 1500 that can be implemented for connection of blind mate connections of modular components (e.g., a pump cassette, an in-rack CDU, modular filtration units, server or network chasses, removable heat exchange modules, etc.) with a liquid cooling system (e.g., an in-rack CDU, an in-row CDU, an RPU, etc.).

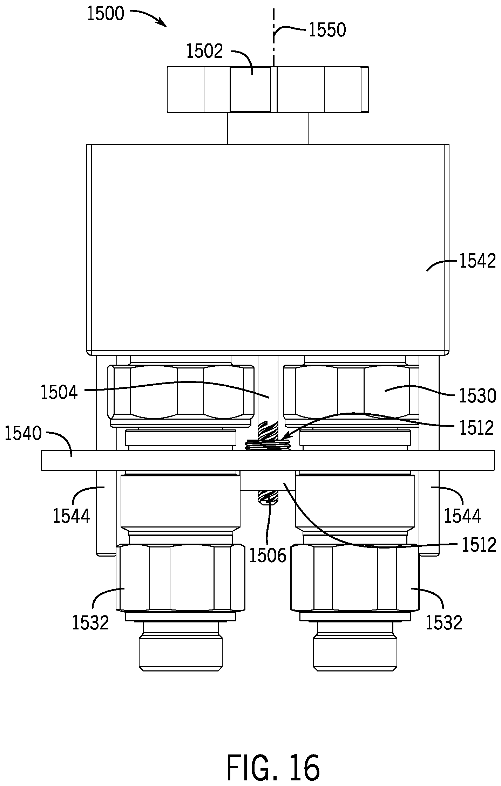

Referring to FIGS. 15 and 16, the actuator assembly 1500 can include a knob 1502 that can actuate the actuator assembly 1500 to bring couplers 1530 (e.g., top couplers) and couplers 1532 (e.g., bottom couplers) into a mating engagement. In some cases, the couplers 1530 can be couplers of a modular component (e.g., a pump cassette, an in-rack CDU, etc.), and the couplers 1532 can be couplers of a liquid cooling system (e.g., quick-disconnect fittings fixed to a housing, a manifold, etc.). In some cases, the couplers 1530 can be couplers of a liquid cooling system (e.g., the actuator assembly 1500 can be fixed to a housing of the liquid cooling system) and the couplers 1532 can be couplers of the modular component (e.g., couplers of the pumps 142 shown in FIGS. 12 and 13). The couplers 1530 can be secured to a housing 1542 (e.g., a manifold block) on a first side of the fluid connection, and the couplers 1532 can be secured to and supported on a mounting plate 1540 (e.g., a guide structure). In some cases, the mounting plate 1540 can be mounted to a structure (e.g., indirectly to a cassette frame of a pump cassette), or the couplers 1532 can be mounted to conduits on a pump. Locating features can be provided for the housing 1542 and the mounting plate 1540 respectively to facilitate an alignment of the respective couplers 1530, 1532 with each other. In the illustrated example, the locating features include pins 1544 that are fixed to the housing 1542. The pins 1544 can be received into corresponding apertures defined in the mounting plate when the housing 1542 and the mounting plate 1540 are appropriately aligned, and when the pins 1544 are received into the apertures, the respective couplers 1530, 1532 can be linearly aligned (e.g., an engagement of the pins 1544 and the corresponding apertures can limit or prevent a lateral displacement and a rotation of the housing 1542 relative to the mounting plate 1540). In some examples, a retention mechanism does not include locating features.

The knob 1502 can be rotated about a central axis 1550 (e.g., a first axis, a rotational axis) that extends in a direction parallel to the couplers 1530 and the couplers 1532 (e.g., the central axis 1550 can be parallel with an insertion direction of the couplers 1530 toward the coupler 1532). For example, the knob 1502 can be rotated manually by a user's fingers or a tool, or programmably (e.g., using a motor). As shown advantageously in FIG. 16, the actuator assembly 1500 includes a lead screw 1504 that is coupled to the knob 1502 (e.g., the lead screw 1504 is coaxial with the knob 1502, configured to rotate about the same axis 1550). A rotation of the knob 1502 about the central axis 1550 can rotate the lead screw 1504 about the central axis 1550 in the same direction. The lead screw 1504 can include a threaded portion 1506 at a distal end of the lead screw 1504, and the threaded portion 1506 can engage a corresponding threaded aperture 1512 (e.g., a threaded nut, a collar, etc.) to selectively secure or disengage the couplers 1530, 1532 with respect to each other (e.g., to linearly translate the couplers 1530 between an engaged or disengaged configuration, respectively). The threaded aperture 1512 can be defined in the mounting plate (e.g., in a collar mounted at the mounting plate 1540). As the lead screw 1504 becomes tightened, the pins 1544 on the housing 1542 can be aligned with or extend through corresponding apertures on the mounting plate 1540. Accordingly, the pins 1544 can guide a linear motion of the housing 1542 and the couplers 1530 secured thereto and enhance alignment between the couplers 1530 and the couplers 1532. In some cases, tubular sleeves can be provided on the mounting plate 1540 and receive the centering pins 1544.

In some examples, a screw (e.g., the threaded portion 1506) can be configured to be self-locking to maintain a modular component within a liquid cooling system. Self-locking screws can be a single-start thread, as can satisfy the self-locking condition articulated in Equation 1 above. However, a single-start thread includes a lead that is equal to a pitch of the thread and a fastener including a single-start thread may require a greater number of turns to achieve a desired tightened engagement between a removable component and a liquid cooling system into which it is installed (e.g., between a pump cassette and an RPU, a removable pump and an in-rack CDU etc.) than the number of turns that would be required if the lead screw included a multi-start thread. Therefore, it may be advantageous to provide an improved retention system that secures a pump cassette in place with a greater ease and efficiency (e.g., less amount of manual effort or fewer turns of a lead screw).

Examples of the present disclosure can provide an improved system and method for efficiently forming a blind mate connection between a pump cassette and an RPU. For example, the threaded portion 1506 can include a multi-start thread, including two starts, three starts, four starts, or more than four starts. Generally, a multi-start thread includes a lead that is greater than a pitch of the thread. Differently put, a multi-start thread can travel a greater distance for one revolution than a single-start thread. Accordingly, a lead screw with a multi-start thread can help securing a pump cassette to an RPU for fewer turns compared to a lead screw with a single-start thread.

In some examples, a lead screw that includes a multi-start thread may not be self-locking. Thus, absent an additional locking mechanisms, a fluid pressure at a fluid connection (e.g., a fluid pressure on the couplers 1530, 1532) can provide a linear force that can produce a rotation of the lead screw and thus a disengagement of the fluid connection (e.g., the threaded portion 1506 can rotate within the threaded aperture 1512 of the mounting plate 1540 producing a linear displacement of the couplers 1530 in a direction away from the couples 1532). Examples of the present disclosure can advantageously provide a locking system to oppose a rotation of a lead screw (e.g., and thus a linear displacement of a removable component and disengagement of fluid couplers of the component from a liquid cooling system) in response to a fluid pressure.

As further shown in FIG. 15, the housing 1542 can house and orient mechanical components (e.g., a ratchet mechanism including a pawl 1510 and a ratchet gear 1508) of the actuator assembly 1500. In some cases, the housing 1542 can define a flow path for fluid flowing through the liquid cooling system. For example, as shown, the housing 1542 includes openings 1543 that can be in fluid communication with the couplers 1530. Hosing can be secured to the openings 1543 to provide a fluid flow through the housing (e.g., a fluid flow through the couplers 1530 and 1532 when engaged). In the illustrated example, the openings 1543 extend in a direction perpendicular to the central axis 1550 or from a front side of the housing 1542 to a rear side of the housing 1542 (e.g., on an opposite side of the front side). In other examples, the openings 1543 can extend at an oblique angle relative to the housing 1542. In some examples, the housing 1542 can include ports that protrude from the housing 1542, such that the ports can be connected to tubes, fittings, or other features within a cooling system. For example, the housing 1542 can include a fill drain port.

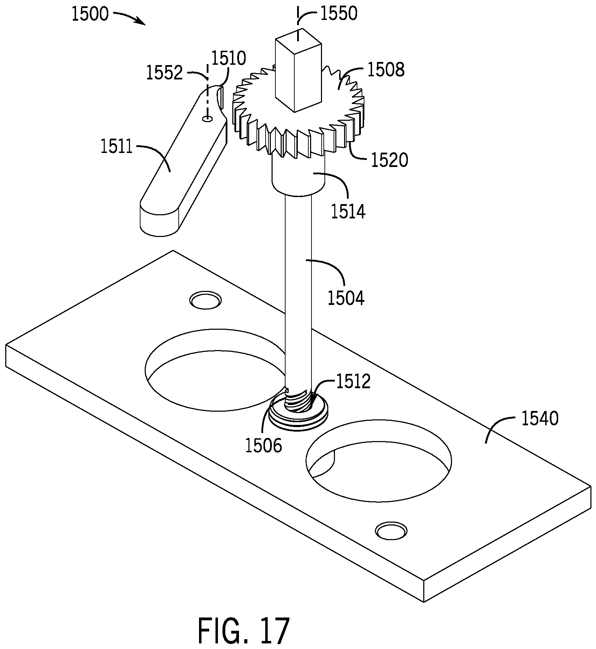

In some examples, a ratchet mechanism can be provided for a lead screw of an actuator assembly (e.g., an actuator assembly for bringing fluid couplers of a liquid cooling system into fluid engagement with fluid couplers of a removable component). As shown in FIGS. 15 and 17, a ratchet gear 1508 can be provided within the housing 1542. A pawl 1510 can be at least partially housed within the housing 1542 and can include a rotatable arm 1511 that extends outwardly from the housing to allow an operator to rotate the arm 1511 disengage the pawl 1510 from the ratchet gear 1508. The housing can at least partially define rotational axes for both of the gear 1508 (e.g., the central axis 1550) and the pawl 1510. In some cases, a pawl can include other mechanisms to selectively engage and disengage a pawl gear. For example, an interface for a pawl can include a spring-loaded knob, a plunger, a depressible button, or any other mechanism that can be engaged to release a pawl from a corresponding ratchet gear.

When the lead screw 1504 is rotated (e.g., through engagement with the knob 1502) in a first direction (e.g., clockwise as viewed from a top of the actuator assembly 1500) to urge the couplers 1530 into engagement with the couplers 1532, , the ratchet mechanism (e.g., an engagement of the pawl 1510 with a tooth of the ratchet gear 1508) can incrementally maintain the rotational position of the lead screw 1504, and thus a linear position of the housing 1542 and the couplers 1530 relative to the couplers 1532. For example, the gear 1508 can rotate with the lead screw 1504 in a first direction (e.g., a clockwise or tightening direction), but the pawl 1510 may prevent the gear 1508 from rotating in a second direction opposite the first direction (e.g., in a counterclockwise or loosening direction). In some cases, the pawl 1510 can include an interface to allow an operator to selectively disengage the pawl 1510 from the ratchet gear 1508 and allow a rotation of the lead screw 1504 in the loosening direction. For example, the pawl 1510 can include an arm (e.g., the arm 1511) that can be displaced by an operator to disengage the pawl from the gear 1508. The ability to selectively engage the arm 1511 to disengage the pawl 1510 from the gear 1508 can provide a greater flexibility in controlling when and how a user disengages the couplers 1530 from the couplers 1532 (e.g., disconnects respective quick-disconnect ports of an actuator assembly of an in-rack CDU from corresponding ports of a removable pump). In some cases, when a pawl 1510 is disengaged, a separating force at the couplers 1530, 1532 (e.g., a force due to fluid pressure) can cause a rotation of the lead screw 1504 and disconnect couplers of the removable component from the fluid cooling system via a linear translation of the couplers 1530 in a direction away from the couplers 1532. The disclosed mechanisms can thus reduce or eliminate a need for an operator to manually rotate the lead screw to disengage a removable component from the liquid cooling system.

FIG. 17 shows the actuator assembly 1500 with housing elements (e.g., the housing 1542) removed to illustrate the gear 1508 (e.g., a ratchet) and the pawl 1510 of the actuator assembly 1500 according to aspects of the present disclosure. As discussed above, the gear 1508 can include a plurality of teeth 1520 that can engage with a distal end of the pawl 1510 to provide a ratcheting engagement therebetween. In the illustrated embodiment, each of the plurality of teeth 1520 extend at an angle (e.g., the teeth define ramped surfaces). Thus, when the pawl 1510 is in contact with the gear 1508 or the plurality of teeth 1520 of the gear 1508, the gear 1508 can rotate in a first direction (e.g., a clockwise direction as shown, or a tightening direction) as the gear 1508 moves past the pawl 1510. However, the gear 1508 may not rotate backward in an opposite direction (e.g., a counterclockwise direction) when the pawl 1510 is in contact with the gear 1508. Accordingly, an engagement between the gear 1508 and the pawl 1510 can maintain an angular orientation of the lead screw 1504, and thus, a linear position of the couplers 1530 along respective axes parallel to the axis 1550. Therefore, the gear 1508 and the pawl 1510 can provide a locking mechanism that locks a position of fluid couplers (e.g., fluid couplers fixed to a manifold block of an in-rack CDU, fluid couplers of a removable pump, a pump cassette etc.) relative to other fluid couplers to which the fluid couplers are configured to mate. In some configurations, the plurality of teeth 1520 can extend at a different angle, such that the gear 1508 can rotate in a counterclockwise direction when the arm 1511 is in contact with the gear 1508. In some cases, the pawl 1510 can be provided at an angle relative to the ratchet gear 1508 (e.g., at a 90-degree angle). The housing 1542 (shown in FIGS. 15 and 16) can define a pawl rotational axis 1552 (e.g., pivot axis) (e.g., a pin can extend through the pawl 1510 and be fixed to the housing to allow the pawl 1510 to rotate about the pin).

Continuing, the pawl 1510 can be disengaged from the gear 1508 by rotating the pawl 1510 about the pawl rotational axis 1552. When the pawl 1510 is disengaged from the gear 1508, the lead screw 1504 can be loosened as the lead screw 1504 rotates in a loosening direction (e.g., a counter-clockwise direction) the central axis 1550 in response to either or both of a fluid pressure at the couplers 1530, 1532, or an operator producing a loosening rotation of the knob 1502. In some cases, friction-reducing elements (e.g., ball bearings) can be used to reduce a friction in rotation of a lead screw and allow a free rotation of the lead screw when a pawl is disengaged. In some cases, the pawl rotational axis 1552 can extend in a direction parallel to the central axis 1550, coaxially with the central axis 1550, or at an angle that is different than the central axis 1550. In the illustrated example, the arm 1511 can extend outwardly from the housing 1542. The arm 1511 can be positioned at the same height as the gear 1508 or offset from the gear 1508 at a distance that can contact the plurality of teeth of the gear 1508. The arm 1511 can be provided in a user-accessible spot of a modular cooling component or a cooling system. For example, the arm 1511 can extend through the housing 1542 or provided on an outer surface of a modular cooling component. In some cases, the arm 1511 may be covered (e.g., with a removable cover) to prevent an undesirable or accidental engagement of the arm 1511 by an operator. In some cases, the arm 1511 can be manually engaged or disengaged. However, in some configurations, a pawl of a retention system can be electrically actuated (e.g., through the use of solenoids, servo motors, etc.).

In some examples, the actuator assembly 1500 can include a bushing 1514 on the lead screw 1504 to constrain a position of the gear 1508 along the central axis 1550. For example, the bushing 1514 can be provided at a predetermined height to position the gear 1508 at a desired height. In some examples, the gear 1508 can include a center aperture that is shaped to fit through a distal end of the lead screw 1504 to secure the gear 1508 to the lead screw 1504. For example, the center aperture of the gear 1508 can include a rectangular cross-section and the distal end of the lead screw 1504 can include a corresponding rectangular cross-section. Accordingly, as the gear 1508 and the lead screw 1504 rotate about the central axis 1550, the gear 1508 can remain stationary relative to the lead screw 1504.

While the description following provides a description of a pawl and ratchet mechanism as a specific example of a locking mechanism, the present disclosure is not limited to this example. In some examples, a variety of locking structures can be used for a retention system, including latch or bolt systems, rotary, or linear cam systems, spring-biased catches, electronic or magnetic systems, or manually or automatically actuated systems, etc. Thus, for example, an actuator assembly can include a rotary cam, spring-biased or lever-operated latch, or other similar extendable/retractable structure, an RPU can include a corresponding recess, protrusion, or other structure that can lockingly engage with the actuator assembly 1500, or *vice versa.*

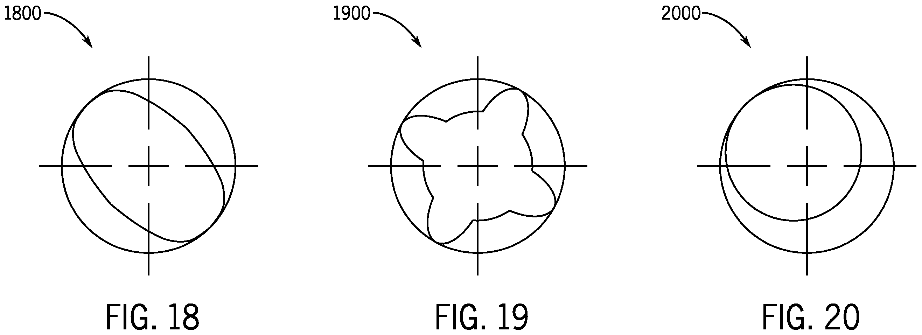

FIGS. 18-20 illustrate example threads that can be implemented on a lead screw such as the lead screw of FIGS. 15-17. In particular, FIGS. 18 and 19 each illustrate a multi-start thread that includes one or more intertwined threads that extend parallel to one another. For example, FIG. 18 illustrates a thread 1800 that is a double-start thread that includes two engaging ends of a thread start. The two engaging ends can be spaced apart by 180 degrees from each other. FIG. 19 illustrates a thread 1900 that is a four-start thread that includes four engaging ends of a thread start. The four engaging ends can be spaced apart by 90 degrees from each other. While the present disclosure shows the thread 1800 and the thread 1900 as exemplary multi-start threads, different multi-start threads including three-start threads, five-start threads, etc. can be provided. Multi-start threads can advantageously increase an efficiency of a blind mate retention mechanism (e.g., the actuator assembly 1500 shown in FIGS. 15-17) by allowing for a greater linear displacement (e.g., in an insertion direction) in response to a rotational displacement, relative to single-start threads. The present disclosure is not limited to multi-start lead screws, and lead screws usable in the disclosed retention mechanisms can include single-start threads for lead screws. FIG. 20, for example, illustrates a thread 2000 that is a single-start thread that includes one starting end of a thread start.

In particular, the thread 1800 or the thread 1900 can provide a greater linear displacement for one revolution of a lead screw than the thread 2000. For example, a lead of a thread is equal to a product of a number of starts and a pitch. Thus, in lead screws with threads having the same pitch, for a given angular rotation about a rotational axis, threads having a higher number of starts can result in a larger displacement in a direction parallel to the rotational axis than threads having a lower number of starts. For applications such as the retention system 2830 or the actuator assembly 1500, engaging a threaded portion of a lead screw or a rod to a corresponding element can be achieved for fewer turns when the threaded portion includes a multi-start thread.

Continuing, the thread 1800 or the thread 1900 may be non-self-locking. In some cases, the thread 1800 or the thread 1900 may not satisfy the self-locking condition of Equation 1 as shown above. For example, a lead screw can be steel, or a threaded nut or brass can be brass. In some non-limiting examples, a retention system can include a coefficient of friction that is about 0.15. In some non-limiting examples, a lead screw can be an American screw thread that includes a major diameter of 0.25 inches and 16 thread per inch. Other types of thread profiles, including a thread pitch, a pitch diameter, a thread angle, etc. are possible.

For multi-start threads that are not self-locking, the actuator assembly 1500 can advantageously provide a locking mechanism that enhances retainment of a screw or loosening of the screw. For example, returning to FIG. 17, disengaging the pawl 1510 from the gear 1508 can release the gear 1508, allowing the gear to rotate in a "loosening" direction. In some cases, hydraulic pressure can be exerted on the couplers 1530 and the couplers 1532 (e.g., hydraulic pressure from a pressurized fluid flowing between the couplers 1530, 1532) and can bias (e.g., push) the couplers 1530 in a direction away from the couplers 1532. With reference to FIGS. 15-17, this pressure can exert a force in a direction parallel to the central axis 1550. When the pawl 1510 is released, the pressure can produce a rotation of lead screw 1504 (e.g., a rotation in a loosening direction about the central axis 1550) and a displacement of the housing 1542 (e.g., and thus the couplers 1530) in a direction away from the couplers 1532 and parallel to the central axis 1550. Disengaging the pawl 1510 from the gear 1508 (e.g., through a rotational displacement of the arm 1511) can thus produce a corresponding disengagement of the couplers 1530, 1532 without an external force (e.g., manual rotation of the knob 1502). Therefore, when the actuator assembly 1500 is incorporated into a liquid cooling system (e.g., to facilitate a blind mate connection for removable pumps within an in-rack CDU), a removable component may be released from a cooling system with a greater ease.

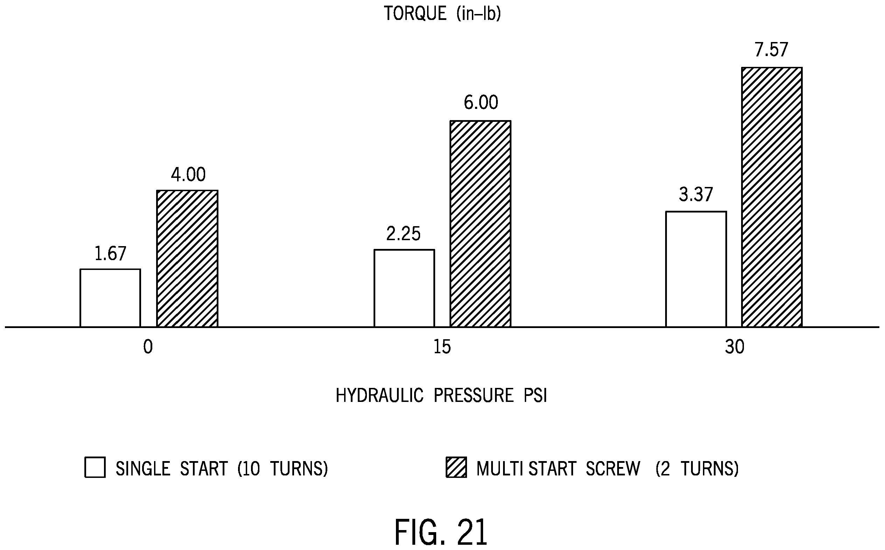

FIG. 21 illustrates a plot showing torque applied to tighten different types of a screws (e.g., such the lead screw 1504 of the actuator assembly 1500) based on a hydraulic pressure due to pressurized liquid coolant. In particular, results of a single-start thread (e.g., such as the thread 2000) and a multi-start thread (e.g., such as the thread 1800 or the thread 1900) were compared. The applied torque values were measured and can be mathematically represented by below Equation 2:

$$T_R = \frac{Fd_m}{2}\left(\frac{l+\pi f d_m sec\alpha}{\pi d_m - fl sec\alpha}\right)(\text{Equation 2})$$

wherein $T_R$ is a required torque to tighten a screw, F is an axial force to tighten a screw, $d_m$ is a mean diameter of a screw, l is a lead of a screw, f is a coefficient of friction, and $\alpha$ is half of a thread angle.

As shown in FIG. 21, a multi-start thread required a greater amount of torque to overcome a hydraulic force than a single-start thread. However, the multi-start thread required a smaller number of turns (e.g., by five times) than the single-start thread to achieve a desired engagement of quick-disconnect couplers (e.g., the couplers 1530 and the couplers 1532). Table 1 shown below summarizes simulated values for the torque required to overcome the hydraulic forces as shown in the plot of FIG. 21.

*Table 1 - Simulated Torque Values at Various Fluid Pressures*

| Measured Values | | |
|---|---|---|
| Hydraulic Pressure (PSI) | Torque (in-lb) | |
| | Single Start Thread (10 Turns) | Multi Start Thread (2 Turns) |
| 0 | 1.67 | 4.00 |
| 15 | 2.25 | 6.00 |
| 30 | 3.37 | 7.57 |

Additionally, specifications and sizes of various components of any of the RPU 2800 or the actuator assembly 1500 can be optimized. For example, profiles of a threaded portion of a lead screw or a threaded rod can be varied. Table 2 below illustrates the results of various simulations of the performance of a retention system having a lead screw of different thread profiles and specifications.

*Table 2 - Simulated Results for Given Lead Screw Properties*

| Thread Type | Single Start | Multi Start (4X) | Units |
|---|---|---|---|
| Nominal Spindle diameter (d) | 0.25 | 0.25 | in |
| Threads Per Inch (TPI) | 16 | 16 | n |
| Number of thread starts | 1 | 4 | - |
| Coefficient of Friction - Static (.1-.2) | 0.15 | 0.15 | - |
| Length of Engagement | 0.625 | 0.625 | in |
| Closing Distance | 1 | 1 | in |
| Load | 89.72 | 89.72 | lb |
| Spindle pitch (p) | 0.0625 | 0.0625 | in |
| Minor Diameter (d1) | 0.1875 | 0.1875 | in |
| Pitch Diameter (d2) or (dm) | 0.2188 | 0.2188 | in |
| Thread Height (h) | 0.0313 | 0.0313 | in |
| Thread Root (F) | 0.0232 | 0.0232 | in |
| Thread Thickness (t) | 0.0393 | 0.0393 | in |
| Thread Angle (2 alpha) | 29 | 29 | ○ |
| Thread Angle/2 (alpha) | 0.2531 | 0.2531 | rad |
| Lead | 0.0625 | 0.25 | |
| Lead angle (°) | 5.1965 | 19.9905 | °degrees |
| Total Installation Torque | 2.48 | 5.43 | in-lb |
| Handle radius | 1 | 1 | in |
| Handle Force | 2.480988036 | 5.42792342 | lbf |

(continued)

| Thread Type | Single Start | Multi Start (4X) | Units |
|---|---|---|---|
| Number of Turns | 16 | 4 | turns |
| Self Locking? | Yes | No | |

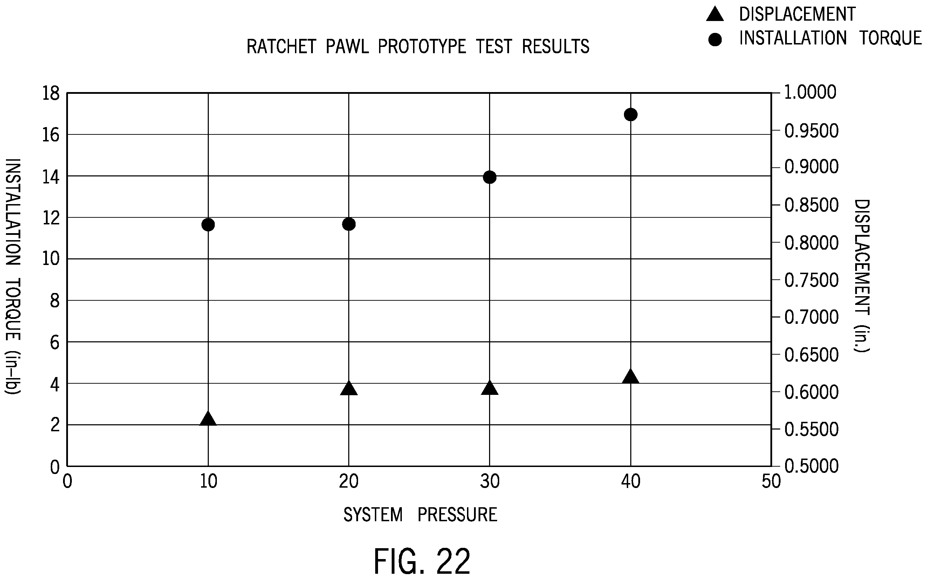

Table 3 shown below illustrates measured test results for a retention system as described above. In particular, the test results show a displacement of a housing assembly (e.g., the housing 1542 shown in FIGS. 15-17) in response to a disengagement of a pawl at a given fluid pressure. These displacement values are shown plotted in the bottom series of the graph illustrated in FIG. 22. The test results of Table 3 and FIG. 22 also show measured values for a torque required to tighten the retention assembly at given fluid pressure values, and the average installation torque values (in in-lb) are also plotted in FIG. 22 on the top series.

*Table 3 - Measured Values for Pump Pressure Test*

| Pressure (PSI) | Initial Displ. (in) | Final Displ. (in) | Total Displacement When Pawl is Released (in.) | Average Installation Torque (in-lb) |
|---|---|---|---|---|
| 10 | 1.1360 | 1.6980 | **0.5620** | 11.63333333 |
| 20 | 1.1360 | 1.7390 | **0.6030** | 11.66666667 |
| 30 | 1.1370 | 1.7400 | **0.6030** | 13.93333333 |
| 40 | 1.1390 | 1.7585 | **0.6195** | 16.96666667 |

FIGS. 23-26 illustrate an example actuator assembly 2300, which can be similar to the actuator assembly 1500 of FIGS. 15-17. To that end, features of the actuator assembly 2300 described below include reference numbers that are generally similar to those used in FIGS. 15-17, and discussion above applies to similar named or numbered items below, unless otherwise noted or required. For example, the actuator assembly 2300 incudes a knob 2302 and a lead screw 2304, just as the actuator assembly 1500 incudes the knob 1502 and the lead screw 1504. Further, absent contrary indication, the principles discussed below, for this and other embodiments, are not limited to a multi-start thread system.

In particular, the lead screw 2304 extends in a direction parallel to a central axis 2350 through a housing 2342 (e.g., a manifold block). The lead screw 2304 includes a threaded portion 2306 that can be configured to threadably engage with a corresponding aperture of a mounting plate (e.g., similar to the mounting plate 1540). For example, the knob 2302 is connected to the lead screw 2304, and a rotation of the knob 2302 about the axis 2350 produces a corresponding rotation of the lead screw 2304 and the threaded portion 2306 about the axis 2350. The knob 2302 can be rotated about a central axis 2350 in a first direction (e.g., clockwise from the perspective of an operator) to tighten the threaded portion 2306 relative to the corresponding aperture (e.g., to translate inlet and outlet openings 2334 in a direction toward the ports with which the inlet and outlet ports are to mate). In some cases, rotating the knob 2302 in a clockwise direction can lower the housing 2342 (e.g., can translate the housing 2342 and elements fixed to the housing in a direction parallel to the axis 2350). Couplers (e.g., quick-disconnect fittings similar to the couplers 1530 of FIGS. 15-17) that can be provided at openings 2334 may engage with corresponding couplers (e.g., similar to the couplers 1532 of FIGS. 15-17) of a component along a liquid cooling circuit (e.g., couplers of a removable pump, removable heat exchanger, filter assembly, etc.), and a flow of pressurized fluids can be discharged from and received into the housing 2342 via respective openings 2343 (e.g., one of the openings 2334 functioning as a fluid outlet and the other opening 2334 functioning as a fluid inlet).

A manifold block of an actuator assembly for blind mate connections can be configured to integrate with liquid plumbing elements of a liquid cooling system as well as providing for alignment of blind matable couplers with blind matable couplers of a removable component. For example, fluid inlets and outlets of a manifold block can be configured to engage with hosing of a liquid cooling system (e.g., an in-rack CDU). In some cases, an orientation of a fluid inlet and fluid outlet of a manifold block can allow for efficient integration with plumbing of the liquid cooling system in which the manifold block is installed. In the illustrated example, the openings 2343 are inlet or outlet openings of the actuator assembly 2300. As shown, the openings 2343 define a fluid flow direction into or out of the housing 2342 in directions that are angled relative to the openings 2334 (e.g., the openings into which the blind matable couplers are installed). In some cases, a manifold block can include more than two openings for an inlet and outlet, as can provide optionality and flexibility for a manifold block of an actuator assembly, allowing an operator to select an orientation that best adapt to space constraints and the orientation of system components of a particular liquid cooling system. In some cases, where multiple options are provided for inlet or outlet openings, an unused opening can be capped (e.g., a flow of fluid through the unused opening can be blocked to prevent a flow of fluid through the unused opening). In some cases, the openings 2334 can be in fluid communication with downstream systems via pipes. In the illustrated example, the openings 2343 extend in a direction different than (e.g., perpendicular to) the central axis 2350. Accordingly, the actuator assembly 2300 can provide a flow of pressurized fluids in a direction different than an orientation of the couplers for blind mate connection.

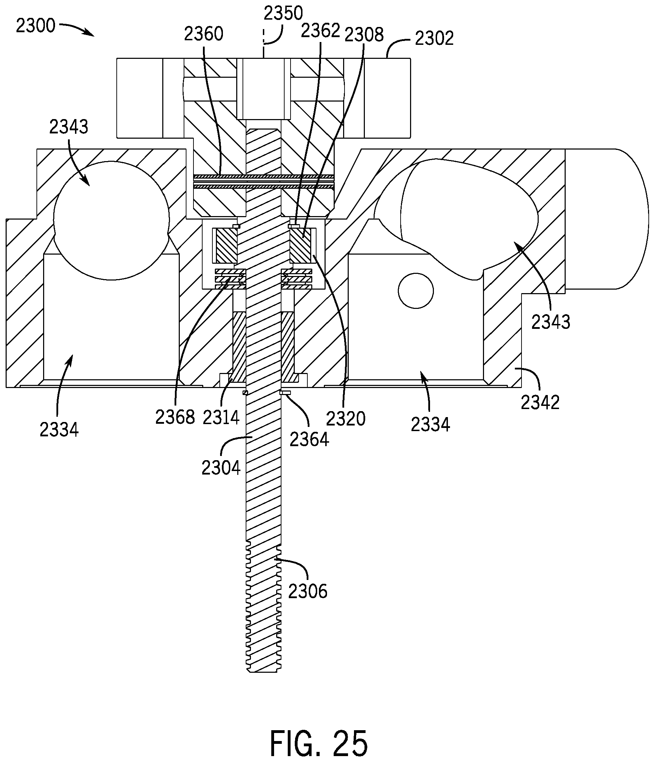

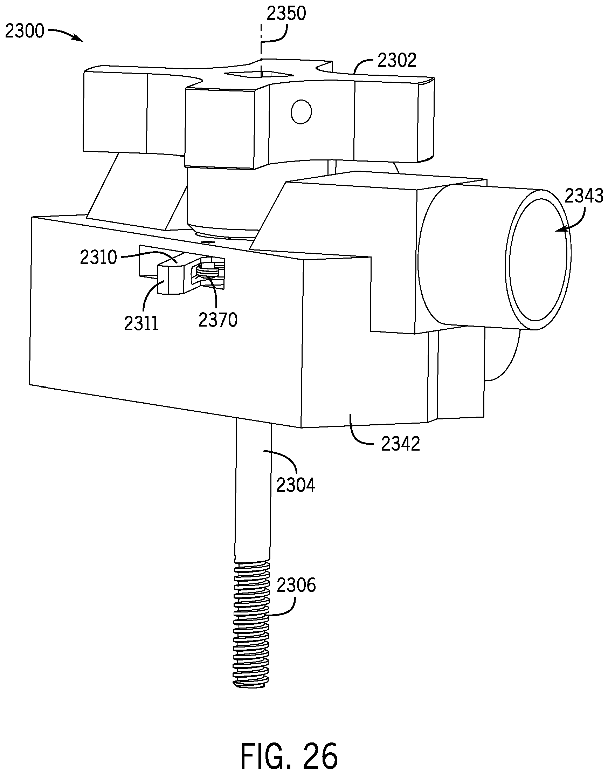

Further, the actuator assembly 2300 includes a ratchet gear 2308 (e.g., shown in FIG. 25) and a pawl 2310 (e.g., shown in FIGS. 23 and 26) that engage with one another when tightening the knob 2302 about the central axis 2350. The ratchet gear 2308 includes a plurality of teeth 2320 that engages with a distal end of the pawl 2310 to provide a ratcheting engagement therebetween. In some cases, the pawl 2310 can be disengaged from the ratchet gear 2308 by actuating (e.g., displacing) an arm 2311 of the pawl 2310. In the illustrated example, a spring 2370 (e.g., shown in FIG. 26) can be provided to bias the pawl 2310 toward an engagement with the gear 2308 when an opposing force from an operator is not applied, and thus prevent rotation of the lead screw 2304 in at least one direction when the operator is not engaging the arm 2311 of the pawl 2310.

With specific reference to FIG. 25, the actuator assembly 2300 includes a plurality of elements and fasteners that help to maintain relative positions of components of the actuator assembly 2300. For example, the bushing 2314 can be provided on the lead screw 2304 and plug a bottom surface of the housing 2342. An upper retainer 2362 and a lower retainer 2364 are provided on the lead screw 2304 and, more particular, on opposite sides of the ratchet gear 2308. Further, a bearing 2368 can be provided along the lead screw 2304 and guide rotational movement of the lead screw 2304 relative to the central axis 2350. Thus, various elements of the actuator assembly 2300 can provide an improved mechanism for a blind mate connection in a direction parallel to the central axis 2350 and a flow of pressurized fluids through the housing 2342.

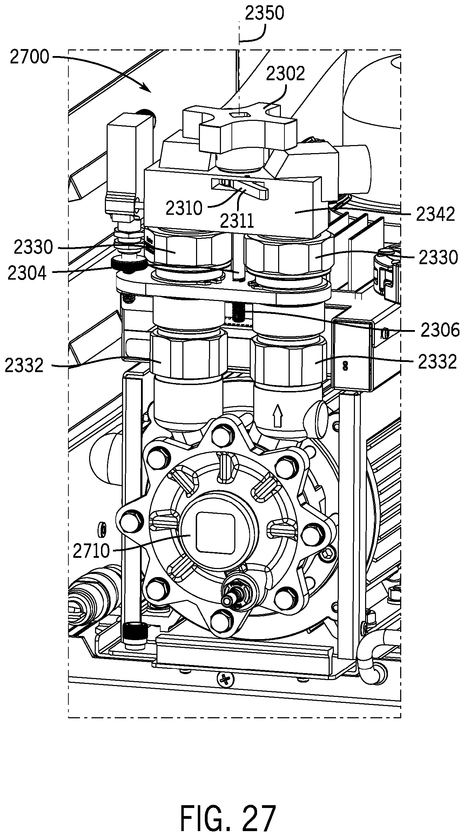

FIG. 27 illustrates the actuator assembly 2300 installed within an in-rack CDU. In the illustrated example, the housing 2342 is connected to couplers 2330 (e.g., similar to the couplers 1530 of FIGS. 15-17). In particular, couplers can be received within a plurality of openings 2334 of the housing 2342. The threaded portion 2306 of the lead screw 2304 can be engaged with a mounting plate (e.g., similar to the mounting plate 1540 of FIGS. 15-17), for example, by rotating the knob 2302 about the central axis 2350. The upper couplers 2330 can engage with couplers 2332 (e.g., similar to the couplers 1532 of FIGS. 15-17). Accordingly, a pump 2710 (e.g., a removable pump) can provide pressurized fluids in a direction parallel to the central axis 2350. The pressurized fluids from the pump 2710 can be routed to downstream systems in a direction different than (e.g., perpendicular to) the central axis 2350 via the housing 2342. The couplers 2330 and the couplers 2332 can be disengaged from one another to stop a flow of the pressurized fluids from the pump 2710 to the housing 2342, for example, by disengaging the pawl 2310 from the ratchet gear 2308 (e.g., as shown in FIG. 25). Thus, the actuator assembly 2300 can enhance the engagement process between the couplers 2330, 2332 and a plurality of pumps 2710 of the in-rack CDU.

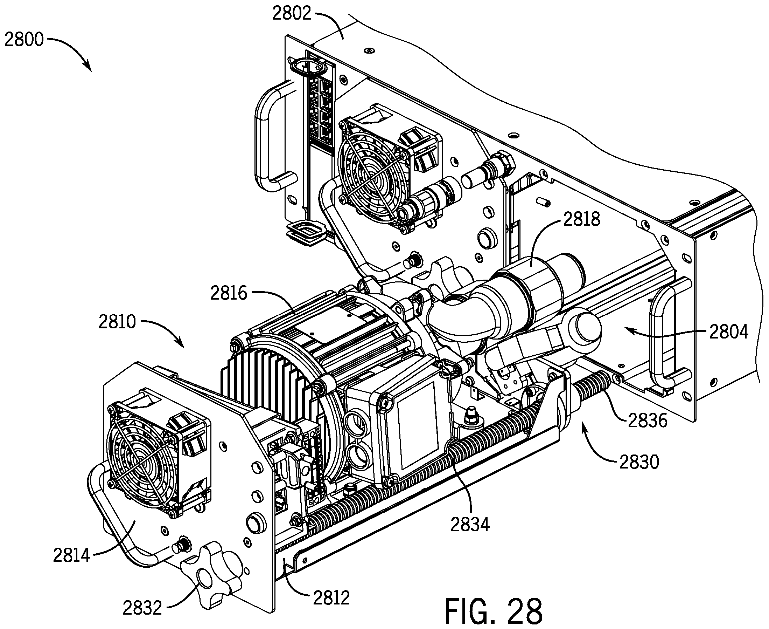

FIG. 28 illustrates aspects of a modular assembly for a liquid cooling system. In the illustrated example, the modular assembly is an RPU 2800 including a housing 2802 that supports various components including a pump, conduits, or couplers (e.g., to provide connections for a liquid coolant loop), and a modular component, which, as shown is a pump cassette 2810. The pump cassette 2810 can be removable from the housing 2802 or hot-swappable in the cooling system. For example, the housing 2802 can include a bay 2804 that is shaped and sized to receive the pump cassette 2810.

As shown, the pump cassette 2810 includes a pump 2816 to pump hydraulic fluids and blind mate couplers 2818 in fluid communication with the pump 2816 (e.g., quick-disconnect inlet and outlet ports). The pump cassette 2810 can include a blind mate coupler 2818 for receiving a fluid (e.g., a return or inlet port) and a blind mate coupler for providing the fluid to the liquid cooling system (e.g., a supply or outlet port). In particular, a coupler 2818 can provide an inlet or outlet connection with the pump 2816 to allow flow of liquid coolant between the pump 2816 and other parts of the cooling system. For example, the coupler 2818 of the cassette frame 2812 can interface (e.g., align with and matingly engage) a coupler provided within the housing 2802. When the blind mate couplers 2818 of the pump cassette 2810 are aligned and matingly engaged with corresponding couplers of the housing 2802, the pump 2816 can provide flow for cooling operations of a cooling system. In the illustrated example, the, couplers 2818 of the pump cassette 2810 and couplers of the housing 2802 are quick-disconnect fittings. In some examples, couplers of the cassette frame 2812 and couplers of the housing 2802 can engage with one another via blind mate connection. For example, a blind mate connection can be formed (e.g., automatically) when the pump cassette 2810 is installed into the bay 2804.

In some cases, retention systems can be provided to secure a connection between fluid ports (e.g., couplers 2818 of the pump cassette and corresponding couples of the housing 2802 shown in FIG. 28). In some examples, the retention mechanisms can be included in a modular component (e.g., the pump cassette 2810) and configured to engage features of a housing or other structure to retain the modular component within the housing, an maintain a fluid connection between the modular component and fluid flow elements within the housing. For example, a retention system can secure a pump cassette in an installed position for cooling operations and can also be engaged to actively move the pump cassette into the installed position. As shown in FIG. 28, a retention system 2830 can be provided on the pump cassette 2810. The retention system 2830 can be a screw locking system that includes a knob 2832 provided on a front panel 2814 and a rod 2834 that is coupled to the knob 2832. The rod 2834 can include a distal threaded portion 2836 that is sized to engage with a threaded aperture (e.g., a threaded nut, a collar, etc.) within the housing 2802 to retain the pump cassette 2810 in place within the bay 2804 and secure a fluid connection between couplers 2818 and corresponding couplers within the housing. While the knob 2832 can be manually rotated to engage the threaded portion 2836 with a corresponding aperture, the knob 2832 need not be manually engaged in some configurations. For example, operation of the retention system 2830 can be automated or electrically driven. Rotation of the knob 2832 (e.g., in a clockwise or counterclockwise direction) can produce a tightening or loosening of the pump cassette 2810 relative to the housing (e.g., can produce a linear displacement of the rod due to the threaded engagement between the threaded portion 2836 and the threaded aperture of the housing 2802). While not shown in FIG. 28, the pump cassette 2810 can include a pawl and ratchet retention mechanism, similar to the pawl and ratchet retention mechanisms described above with respect to FIGS. 15-26.

Knobs of an actuator assembly for blind mate connections can include features to allow a compatibility with various engagement methods for the knob. For example, a knob can include a protrusion or aperture that can engage with a tool head as can allow an operator to rotate the knob (e.g., and thus a lead screw) using a tool with a tool head capable of engaging the aperture or protrusion. In some cases, a knob can include multiple engagement interfaces as can allow for engagement using multiple different tool heads, or a manual engagement. In some cases, for example, a knob can include engagement features that are respectively compatible with respective standards (e.g., standard tool head configurations and sizes for imperial and metric measurement systems), as can advantageously allow for a manufacturing of a single knob type that can be usable in jurisdictions or contexts in which different measurement systems are used.

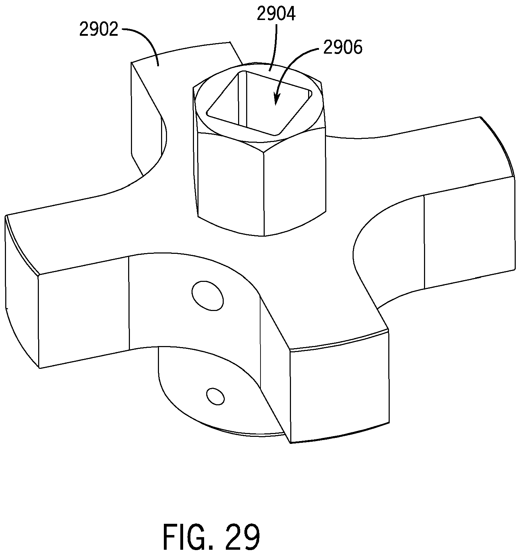

FIG. 29 illustrates a knob 2902 (e.g., a rotatable knob) for a retention system of the pump cassette (e.g., similar or identical to the knob 1502 shown in FIGS. 15 and 16, and the knob 2302 shown in FIGS. 23-25). In particular, the knob 2902 includes particular geometries and shapes that are configured to engage with a desired tool (e.g., a wrench, an adjustable wrench, an Allen wrench, a screwdriver, a ratchet wrench, a hand drill, a motorized drill, etc.). In the illustrated example, the knob 2902 includes a protruding head 2904 that extends from a top surface of the knob 2902. As shown, the head 2904 has a hexagonal shape that can be engaged using a hex-head socket of a socket wrench or a drill. As further shown, the head 2904 can include an opening 2906 that can engage with a tool head that can be different from the tool head that engages with the protruding head 2904. As shown, the opening 2906 defines a square profile and can receive a square bit (e.g., a square bit of a drill, a screwdriver, etc.). In some cases, the opening 2906 can receive a tool head using an imperial measurement standard (e.g., can receive a .375-inch square tool head), and the protruding head 2904 can be sized to be compatible with a socket adhering to metric standards. In some cases, a protruding head can adhere to an imperial measurement system (e.g., can be received into a socket using an imperial sizing) and the opening can adhere to an imperial measurement standard. As shown, then, the knob 2902 can provide an option for a user to engage the knob manually (e.g., a user can engage the arms of the knob 2902 with their hands to rotate the knob), or with either of a first (e.g., a hexagonal head socket) and second (e.g., a square head bit of a drill, screwdriver, wrench, etc.) tooled engagement method. Therefore, a user can more easily engage with the knob 2902 to control operation of a retention system for a cooling unit.

The previous description of the disclosed embodiments is provided to enable any person skilled in the art to make or use the disclosed technology. Various modifications to these embodiments will be readily apparent to those skilled in the art, and the generic principles defined herein may be applied to other embodiments without departing from the spirit or scope of the disclosed technology. Thus, the disclosed technology is not intended to be limited to the embodiments shown herein but is to be accorded the widest scope consistent with the principles and novel features disclosed herein.

As used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of' (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In some implementations, devices or systems disclosed herein can be utilized, manufactured, installed, etc. using methods embodying aspects of the disclosed technology. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as embodiments of the disclosed technology, of the utilized features and implemented capabilities of such device or system.

Certain operations of methods according to the disclosed technology, or of systems executing those methods, may be represented schematically in the FIGS., or otherwise discussed herein. Unless otherwise specified or limited, representation in the FIGS. of particular operations in particular spatial order may not necessarily require those operations to be executed in a particular sequence corresponding to the particular spatial order. Correspondingly, certain operations represented in the FIGS., or otherwise disclosed herein, can be executed in different orders than are expressly illustrated or described, as appropriate for particular embodiments of the disclosed technology. Further, in some embodiments, certain operations can be executed in parallel, including by dedicated parallel processing devices, or separate computing devices configured to interoperate as part of a large system.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom. Features of the blind-mate connection system or other apparatus or component(s) described may be incorporated into/used in a corresponding method and vice versa.

As used herein in the context of computer implementation, unless otherwise specified or limited, the terms "component," "system," "module," "block," and the like are intended to encompass part or all of computer-related systems that include hardware, software, a combination of hardware and software, or software in execution. For example, a component may be, but is not limited to being, a processor device, a process being executed (or executable) by a processor device, an object, an executable, a thread of execution, a computer program, or a computer. By way of illustration, both an application running on a computer and the computer can be a component. One or more components (or system, module, and so on) may reside within a process or thread of execution, may be localized on one computer, may be distributed between two or more computers or other processor devices, or may be included within another component (or system, module, and so on).

Also as used herein, unless otherwise limited or defined, the terms "about," "substantially," and "approximately" refer to a range of values $\pm$ 5% of the numeric value that the term precedes. As a default the terms "about" and "approximately" are inclusive to the endpoints of the relevant range, but disclosure of ranges exclusive to the endpoints is also intended.

Also as used herein, unless otherwise limited or defined, "integral" and derivatives thereof (e.g., "integrally") describe elements that are manufacture as a single piece without fasteners, adhesive, or the like to secure separate components together. For example, an element stamped as a single-piece component from a single piece of sheet metal, without rivets, screws, or adhesive to hold separately formed pieces together is an integral (and integrally formed) element. In contrast, an element formed from multiple pieces that are separately formed initially then later connected together, is not an integral (or integrally formed) element.

Also as used herein, unless otherwise defined or limited, the term "lateral" refers to a direction that does not extend in parallel with a reference direction. A feature that extends in a lateral direction relative to a reference direction thus extends in a direction, at least a component of which is not parallel to the reference direction. In some cases, a lateral direction can be a radial or other perpendicular direction relative to a reference direction.

As used herein, unless otherwise defined or limited, two components that are described herein as "aligned", relative to a reference direction, are each at least partly located along a common reference line in the reference direction. Thus, for example, components that are described as "vertically aligned" are aligned along a common vertical line.

Unless otherwise specifically indicated, ordinal numbers are used herein for convenience of reference, based generally on the order in which particular components are presented in the relevant part of the disclosure. In this regard, for example, designations such as "first," "second," etc., generally indicate only the order in which a thus-labeled component is introduced for discussion and generally do not indicate or require a particular spatial, functional, temporal, or structural primacy or order. Relatedly, similar or identical components may be referred to with different ordinal numbers in different contexts.

Also as used herein, unless otherwise defined or limited, directional terms are used for convenience of reference for discussion of particular figures or examples or to indicate spatial relationships relative to particular other components or context, but are not intended to indicate absolute orientation. For example, references to downward, forward, or other directions, or to top, rear, or other positions (or features) may be used to discuss aspects of a particular example or figure, but do not necessarily require similar orientation or geometry in all installations or configurations.

**Claims**

1. A blind-mate connection system for fluid ports of a liquid cooling system including a removable component with a first fluid coupler and a second fluid coupler, the blind-mate connection system including:

   a housing including a fluid inlet and a fluid outlet;
   an inlet fluid coupler in fluid communication with the fluid inlet and an outlet fluid coupler in fluid communication with the fluid outlet;

   the inlet fluid coupler and the outlet fluid coupler being fixed to the housing;
   the inlet fluid coupler engaging the first fluid coupler of the removable component and the outlet fluid coupler engaging the second fluid coupler of the removable component;
   the inlet fluid coupler and the outlet fluid coupler facing in a first direction allowing fluid flow through the first fluid coupler and the second fluid coupler parallel to a first axis;

   a guide structure to at least partially constrain movement of the housing in a second direction transverse to the first axis;
   a manual engagement interface to rotate about a rotation axis, rotation of the manual engagement interface producing a linear translation of the housing in a third direction parallel to the first axis; and
   a retention mechanism to oppose rotation of the manual engagement interface about the rotation axis in a fourth direction opposite the first direction.

2. The blind-mate connection system of claim 1, further comprising:

   a lead screw with a threaded end, the lead screw rotatable about the rotation axis,
   wherein the manual engagement interface includes a knob, wherein rotation of the knob produces rotation of the lead screw, and wherein the first axis is parallel to the rotation axis.

3. The blind-mate connection system of claim 2, wherein the retention mechanism comprises:

   a ratchet gear secured to the lead screw and positioned within the housing; and
   a pawl movable between an engaged configuration and a disengaged configuration, the pawl being in contact with the ratchet gear in the engaged configuration and not in contact with the ratchet gear in the disengaged configuration.

4. The blind-mate connection system of claim 2 or claim 3, wherein the threaded end comprises a multi-start thread.

5. The blind-mate connection system of claim 2, claim 3 or claim 4, wherein the guide structure comprises a plate defining a threaded aperture, wherein the threaded end is sized to be received into the threaded aperture.

6. The blind-mate connection system of claim 2 or of any of claims 2 to 5, wherein the knob defines a square opening sized to receive a square head of a tool.

7. The blind-mate connection system of claim 1 or of any of claims 2 to 6, wherein the manual engagement interface includes a handle movable between an open position and a closed position, wherein the rotational axis is transverse to the first axis.

8. The blind-mate connection system of claim 7, wherein the guide structure comprises:

   a mounting structure including a protruding pin, the mounting structure at least partially receiving the housing; and
   a bracket including an elongate slot extending in a direction parallel to the first axis, wherein the protruding pin of the mounting structure is received within the elongate slot.

9. A method of establishing a blind-mate connection for fluid ports of a liquid cooling system, the method comprising:

   positioning a housing defining a fluid inlet and a fluid outlet, the housing having an inlet fluid coupler in fluid communication with the fluid inlet and an outlet fluid coupler in fluid communication with the fluid outlet, the inlet fluid coupler and the outlet fluid coupler fixed to the housing and facing in a first direction, the inlet fluid coupler and the outlet fluid coupler allowing a flow of fluid in a direction parallel to a first axis;
rotating a manual engagement interface about a rotation axis in a first direction to produce a linear translation of the housing in an insertion direction, the insertion direction being parallel to the first axis, to matably engage the inlet fluid coupler and the outlet fluid coupler with corresponding fluid couplers of a removable component; and engaging a retention mechanism to oppose rotation of the manual engagement interface about the rotation axis in a direction opposite the first direction.

10. The method of claim 9, wherein
rotating the manual engagement interface comprises rotating a knob to produce a corresponding rotation of a lead screw about the rotation axis.

11. The method of claim 10, wherein engaging the retention mechanism comprises:
engaging a pawl with a ratchet gear secured to the lead screw and positioned within the housing, wherein the pawl is movable between an engaged configuration and a disengaged configuration, the pawl being in contact with the ratchet gear in the engaged configuration and not in contact with the ratchet gear in the disengaged configuration.

12. The method of claim 10 or claim 11, wherein rotating the lead screw includes rotating the lead screw that includes a multi-start thread.

13. The method of claim 10, claim 11 or claim 12 further comprising engaging a threaded end of the lead screw with a guide structure to constrain movement of the housing in a direction transverse to the first axis.

14. The method of claim 9 or of any of claims 10 to 13,

wherein the manual engagement interface includes a handle movable between an open position and a closed position, and
wherein rotating the manual engagement interface comprises moving the handle from the open position to the closed position.

15. The method of claim 14, wherein the rotational axis is transverse to the first axis.

FIG. 1

FIG. 2

FIG. 3

FIG. 4

FIG. 5

FIG. 6

FIG. 7

EP 4 642 179 A2

FIG. 8

FIG. 10

FIG. 9

FIG. 11

FIG. 12

FIG. 13

EP 4 642 179 A2

CAM MECHANISM MECHANICAL ADVANTAGE

FIG. 14

FIG. 15

FIG. 16

FIG. 17

FIG. 18

FIG. 19

FIG. 20

TORQUE (in-lb)

HYDRAULIC PRESSURE PSI

□ SINGLE START (10 TURNS)        ▨ MULTI START SCREW (2 TURNS)

FIG. 21

RATCHET PAWL PROTOTYPE TEST RESULTS

▲ DISPLACEMENT
● INSTALLATION TORQUE

FIG. 22

EP 4 642 179 A2

FIG. 23

FIG. 24

FIG. 25

**FIG. 26**

FIG. 27

FIG. 28

EP 4 642 179 A2

FIG. 29

**REFERENCES CITED IN THE DESCRIPTION**

**Patent documents cited in the description**

- US 63572608
- US 63694633